# EUROPÄISCHE PATENTSCHRIFT

(11) **EP 4 241 344 B1**
(45) Veröffentlichungstag und Bekanntmachung des Hinweises auf die Patenterteilung: **16.07.2025**
(21) Anmeldenummer: 21759084.3
(22) Anmeldetag: 13.08.2021
(51) Int. Cl.: H01R 25/14, E04B 2/74, F21V 21/002, H01R 13/62

(54) **OBERFLÄCHENFUNKTIONSSYSTEM, VERWENDUNG DES OBERFLÄCHENFUNKTIONSSYSTEMS, GEBÄUDEWAND UND AKUSTIKKÖRPER**
SURFACE FUNCTION SYSTEM, USE OF THE SURFACE FUNCTION SYSTEM, BUILDING WALL, AND ACOUSTIC ELEMENT
SYSTÈME À FONCTION DE SURFACE, UTILISATION DU SYSTÈME À FONCTION DE SURFACE, PAROI DE CONSTRUCTION ET ÉLÉMENT ACOUSTIQUE

(43) Veröffentlichungstag der Anmeldung: 13.09.2023
(73) Patentinhaber: FLEXFY GmbH, 64380 Roßdorf (DE)
(72) Erfinder: WALTER, Christian, 64354 Reinheim (DE); SCHRÖPFER, Anja, 64380 Roßdorf (DE); FRANKE, Victor, 64285 Darmstadt (DE)
(74) Vertreter: Metten, Karl-Heinz
(86) Internationale Anmeldenummer: PCT/EP2021/072618
(87) Internationale Veröffentlichungsnummer: WO 2023/016656

(56) Entgegenhaltungen:
- DE-U1- 202019 005 339
- US-A- 4 578 731
- US-A1- 2010 219 183
- US-A1- 2015 303 736

## Beschreibung

Die Erfindung betrifft ein Oberflächenfunktionssystem für die Flächenstromversorgung im Niedervoltbereich, insbesondere ein Gebäudeoberflächenfunktionssystem, sowie die Verwendung des Oberflächenfunktionssystems. Die Erfindung betrifft auch eine Gebäudewand. Ferner betrifft die Erfindung einen Akustikkörper.

Die US 2009/0219712 A1 beschreibt ein Beleuchtungssystem mit einer elektrisch leitfähigen Tapete. Die Tapete kann an einer Gebäudewand oder -decke angebracht werden. An der Tapete ist eine Vielzahl elektrisch leitfähiger Streifen vorgesehen. Elektrische Leuchtmittel können durch Kontaktpins mit den leitfähigen Streifen verbunden werden. Die Streifen und Kontaktpins sind in einem bestimmten Abstand zueinander vorgesehen, damit Streifen unterschiedlichen Potenzials mit verschiedenen Kontaktpins in Kontakt gebracht werden können. Die Verwendung des Beleuchtungssystems ist fehleranfällig. Beim Anbringen eines Leuchtmittels wird häufig nicht die für den Betrieb des Leuchtmittels erforderliche elektrische Verbindung geschlossen. Schlimmstenfalls kann es zu Kurzschlüssen kommen.

Aus der US 2010/0327744 A1 ist ein anderes Beleuchtungssystem mit einer Elektrodenvorrichtung und einem elektrischen Leuchtmittel bekannt. Die Elektrodenvorrichtung umfasst zwei Elektroden unterschiedlicher Polarität, die kammartig einander greifen, und eine die Elektroden bedeckende Abschirmung. Mit der Abschirmung kann die Elektrodenvorrichtung eine Wand- oder Deckenfassade bilden. Das Leuchtmittel hat eine Basis mit mehreren nadelförmigen Kontaktelementen, um durch die Abschirmung zu den Elektroden zu dringen. Die Kontaktelemente sind in einer Dreieckskonfiguration angeordnet. Die Form und Größe der Elektroden und damit der Elektrodenvorrichtung ist unveränderlich festgelegt. Individuelle Maßanfertigungen führen zu sehr hohen Kosten und sind daher kaum verbreitet. Selbst kleine Beschädigungen der Elektrodenvorrichtung führen häufig zu Kurzschlüssen der beiden Elektroden und dadurch zu einem vollständigen Ausfall des Beleuchtungssystems.

DE 20 2019 005339 U1 offenbart ein System, insbesondere für einen Präsentations-, Verkaufs- oder Messestand und/oder für den Ladenbau, mit einem stromführenden Wandelement und einem Stromabnehmer für einen elektrischen Verbraucher, der dazu eingerichtet ist, an dem Wandelement befestigt zu werden, wobei das Wandelement eine Trägerplatte mit einer Vorderseite und einer Rückseite aufweist, wobei das Wandelement erste elektrische Leiterbahnen einer ersten Polarität und zweite elektrische Leiterbahnen einer zweiten Polarität aufweist, wobei die ersten und zweiten elektrischen Leiterbahnen zumindest abschnittsweise abwechselnd angeordnet sind; wobei die ersten elektrischen Leiterbahnen und die zweiten elektrischen Leiterbahnen auf der Vorderseite der Trägerplatte angeordnet sind, wobei der Stromabnehmer eine Mehrzahl von wenigstens zwei Kontaktnadeln aufweist, wobei der Stromabnehmer dazu eingerichtet ist, an dem Wandelement derart befestigt zu werden, dass zumindest eine der Kontaktnadeln eine der ersten elektrischen Leiterbahnen kontaktiert und zumindest eine andere der Kontaktnadeln eine der zweiten elektrischen Leiterbahnen kontaktiert, und wobei das Wandelement einen ersten elektrischen Anschlusskontakt und einen zweiten elektrischen Anschlusskontakt aufweist, wobei der erste elektrische Anschlusskontakt mit den ersten elektrischen Leiterbahnen elektrisch leitend verbunden ist, wobei der zweite elektrische Anschlusskontakt mit den zweiten elektrischen Leiterbahnen elektrisch leitend verbunden ist, und wobei der erste elektrische Anschlusskontakt und der zweite elektrische Anschlusskontakt auf der Rückseite der Trägerplatte angeordnet sind.

US 2015/303736 A1 und US 2010/7219183 A1 offenbaren andere Oberflächenfunktionssysteme.

Der vorliegenden Erfindung lag die Aufgabe zugrunde, die Nachteile des Stands der Technik zu überwinden, insbesondere ein Oberflächenfunktionssystem, vorzugsweise für eine Gebäudewand und/oder einen Akustikkörper, bereitzustellen, das auch großtechnisch einfach und kostengünstig herstellbar ist, das einfach auf verschiedenste Gegebenheiten anpassbar ist und/oder mit dem sich ortsungebunden sicher, zuverlässig und einfach eine, insbesondere reversible, elektrische Kontaktierung erreichen lässt.

Diese Aufgabe wird durch ein Oberflächenfunktionssystem für die Flächenstromversorgung im Niedervoltbereich gemäß Anspruch 1 gelöst. Demgemäß ist ein, insbesondere modulares, Oberflächenfunktionssystem für eine Flächenstromversorgung im Niedervoltbereich vorgesehen, insbesondere ein Gebäudeoberflächenfunktionssystem. Ein Gebäudeoberflächenfunktionssystem kann insbesondere dazu ausgelegt sein, eine Gebäudeoberfläche, wie eine Mauerwerksoberfläche, zu nutzen bzw. zu belegen. Eine Stromversorgung im Niedervoltbereich bezeichnet im Allgemeinen eine Stromversorgung signifikant unterhalb der Netzspannung von 230 V. Vorzugsweise ist die Stromversorgung im Niedervoltbereich eine Stromversorgung im Bereich von 48 V oder weniger, insbesondere 24 V oder weniger, vorzugsweise 12 V oder weniger, besonders bevorzugt 6 V oder weniger.

Das erfindungsgemäße Oberflächenfunktionssystem umfasst ein Trägersystem, eine Vielzahl an Flächenleiterbahnen und eine Kontaktleiste mit mindestens zwei Leiterbändern. Vorzugsweise sind alle der Vielzahl an Flächenleiterbahnen in derselben Ebene des Oberflächenfunktionssystems und/oder des Trägersystems angeordnet. Vorzugsweise sind alle der Vielzahl an Flächenleiterbahnen transversal nebeneinander angeordnet. Eine Flächenleiterbahn kann im Allgemeinen eine elektrisch leitfähige Bahn bezeichnen, deren longitudinale Haupterstreckungsrichtung wesentlich größer ist als deren Dicke, insbesondere wenigstens hundertmal größer, vorzugsweise wenigstens tausendmal größer. Alternativ oder zusätzlich kann eine Flächenleiterbahn im Allgemeinen eine elektrisch leitfähige Bahn bezeichnen, die quer zur Haupterstreckungsrichtung eine Transversalbreite hat, die wesentlich kleiner ist als ihre longitudinale Hauptstreckung, insbesondere wenigstens 10 mal kleiner oder wenigstens hundertmal kleiner, und die wesentlich größer ist als die Dicke der Flächenleiterbahn, insbesondere wenigstens 10 mal größer oder wenigstens hundertmal größer. Beispielsweise kann eine Flächenleiterbahn eine longitudinale Hauptstreckung von wenigstens 1m und eine Dicke von weniger als 0,5 mm, insbesondere weniger als 0,1 mm, aufweisen, sowie gegebenenfalls eine Transversalbreite im Bereich von 1 mm bis 10 cm, vorzugsweise im Bereich 1 cm bis 5 cm. Bei einer bevorzugten Ausführungsform kann die Flächenleiterbahn als vollflächige Leiterbahn ausgebildet sein. Alternativ ist es denkbar, dass die Flächenleiterbahn sich zusammensetzt aus einer Vielzahl dünner benachbarter Leiterbahnabschnitte, die insbesondere zumindest abschnittsweise gitterförmig, schachbrettmusterartig, rasterförmig, netzförmig und/oder mäanderförmig sind, und die gemeinsam, beispielsweise als Netz, die Flächenleiterbahn bilden. Der Abstand solcher benachbarter Leiterbahnabschnitte einer Flächenleiterbahn ist stets kleiner als eine Kontaktstelle. In Kombination mit der unten beschriebenen bevorzugten Ausführungsform, die kooperiert mit wenigstens einem Stromaufnehmer mit mehreren Kontaktelementen, ist der Abstand solcher benachbarter Leiterbahnabschnitte einer Flächenleiterbahn stets kleiner als die größte Querschnittsbreite der Kontaktelemente.

Das Trägersystem kann insbesondere als eine Trägerlage gebildet sein. Ein Trägersystem kann vorzugsweise als eine flächige und/oder quasi-zwei-dimensionale Trägerlage gebildet sein. Die Trägerlage kann beispielsweise eine longitudinale Längserstreckung und eine transversale Quererstreckung aufweisen, die sehr viel größer sind als eine Dicke der Trägerlage. Bei einem Gebäudewand-Oberflächenfunktionssystem kann die longitudinale Längserstreckung der Vertikalrichtung entsprechen, die transversale Querstreckung kann einer insbesondere primären Horizontalrichtung entsprechen und/oder die Dicke des Trägersystems, insbesondere der Trägerlage, kann einer Tiefen-Richtung beziehungsweise sekundären Horizontalrichtung entsprechen. Alternativ kann bei einem Gebäudedecken-Oberflächenfunktionssystem die longitudinale Längserstreckung einer ersten insbesondere primären Horizontalrichtung entsprechen, die transversale Querstreckung kann einer zweiten insbesondere primären Horizontalrichtung entsprechen und/oder die Dicke des Trägersystems, insbesondere der Trägerlage, kann einer Vertikalrichtung entsprechen. Die Trägerlage kann beispielsweise als Bahnmaterial gebildet sein oder als Oberflächenbeschichtung.

Das Oberflächenfunktionssystem umfasst eine Vielzahl an longitudinalen elektrischen Flächenleiterbahnen mit jeweils einem Anschlussende. Die Vielzahl an elektrischen Flächenleiterbahnen liegen vorderseitig an dem Trägersystem vor, liegen rückseitig an dem Trägersystem vor und/oder liegen eingebettet in das Trägersystem vor. Es ist denkbar, dass eine erste Gruppe Flächenleiterbahnen vorderseitig an dem Trägersystem vorliegt, dass eine zweite Gruppe Flächenleiterbahnen rückseitig an dem Trägersystem vorliegt und/oder dass eine dritte Gruppe Flächenleiterbahnen eingebettet in das Trägersystem vorliegt. Insbesondere können alle der Vielzahl an elektrischen Flächenleiterbahnen vorderseitig oder rückseitig an dem Trägersystem oder eingebettet in das Trägersystem vorliegen. Die Rückseite des Trägersystems kann bei einem Gebäudeoberflächenfunktionssystem dazu ausgelegt und eingerichtet sein, mit einer Gebäudewand, insbesondere einem Mauerwerk, in Kontakt bringbar zu sein oder zu stehen. Die Anschlussenden sind nebeneinander angeordnet. Vorzugsweise sind mehrere oder alle der Anschlussenden der Vielzahl an longitudinalen elektrischen Flächenleiterbahnen neben einander in einem sich quer (transversal), insbesondere orthogonal, zu der longitudinalen Richtung entlang des Trägersystems erstreckenden Anschlussbereich nebeneinander angeordnet, wobei insbesondere der Anschlussbereich in der longitudinalen Richtung schmaler ist als quer dazu, insbesondere wenigstens 10 mal schmaler oder wenigstens 15 mal schmaler. Insbesondere kann vorgesehen sein, dass mehrere oder alle der Anschlussenden der Vielzahl elektrischer Flächenleiterbahnen des Oberflächenfunktionssystems an der gleichen sich in transversaler Richtung erstreckenden Longitudinalrandkante nebeneinander angeordnet sind. Bei einem Gebäudeoberflächenfunktionssystem kann die longitudinale Richtung zu der Vertikalrichtung korrespondieren und/oder die transversale Richtung zu einer Horizontalrichtung korrespondieren. Das erfindungsgemäße Oberflächenfunktionssystem ist dazu ausgelegt und eingerichtet, dass die Flächenleiterbahnen durch die nachfolgend beschriebene Kontaktleiste, insbesondere ausschließlich, an nebeneinander angeordneten Anschlussenden, insbesondere entlang der Longitudinalrandkante und/oder in dem Anschlussbereich, für eine elektrische Verbindung kontaktierbar oder kontaktiert sind. Insbesondere kann vorgesehen sein, dass bei einem jeweiligen Trägersystem, insbesondere Trägerlage, die Flächenleiterbahnen jeweils ein zweites Ende in longitudinaler Richtung gegenüber zum Anschlussende aufweisen, wobei die zweiten Enden benachbart zueinander angeordnet sind, wobei insbesondere vorgesehen ist, dass die zweiten Enden frei von einer Kontaktierung zur elektrischen Verbindung mit der Kontaktleiste oder einer anderen Stromversorgungsquelle sind. Es sei klar, dass die Anschlussenden und die zweiten Enden strukturell gleichartig sein können. Insbesondere können die zweiten Enden eines ersten Trägersystem-Abschnitts und die Anschlussenden eines zweiten Trägersystem-Abschnitts durch Teilen, vorzugsweise Einkürzen, eines Trägersystems in transversaler Richtung quer, insbesondere orthogonal, zu der longitudinalen Richtung gebildet sein, wobei insbesondere jeder Trägersystem-Abschnitt ein neues Trägersystem bildet.

Das erfindungsgemäße Oberflächenfunktionssystem umfasst ferner eine, insbesondere flexible, elektrische Kontaktleiste. Die elektrische Kontaktleiste enthält mindestens ein erstes elektrisch leitfähiges Leiterband und mindestens ein zweites elektrisch leitfähiges Leiterband. Das erste und das zweite Leiterband verlaufen benachbart zueinander, bevorzugt durch einen Transversalabstand voneinander getrennt. Insbesondere verlaufen das erste und das zweite Leiterband in transversaler Richtung, vorzugsweise in Horizontalrichtung, und weisen eine schmale Erstreckung in longitudinaler Richtung, vorzugsweise in Vertikalrichtung, auf. Insbesondere können das erste und das zweite Leiterband im Wesentlichen parallel zueinander verlaufen. Das erste Leiterband ist mit einem ersten Pol einer Gleichspannungsquelle verbindbar und das zweite Leiterband ist mit einem zweiten Pol der Gleichspannungsquelle verbindbar. Als Gleichspannungsquelle kann beispielsweise eine Photovoltaikanlage, ein Speicherakku oder eine Speicherakkuanordnung, eine Brennstoffzelle dienen, wobei die Gleichspannungsquelle in oder an einem Gebäude befestigt sein kann, an dem auch das Oberflächenfunktionssystem anbringbar oder angebracht ist. Bei einer bevorzugten Ausführung ist das erste Leiterband mit dem ersten Pol und/oder das zweite Leiterband mit dem zweiten Pol der Gleichspannungsquelle verbunden. Die Pole der Gleichspannungsquelle weisen vorzugsweise eine Potenzialdifferenz im Niedervoltbereich auf. Das erste Leiterband weist eine Vielzahl an Kontaktstellen für die elektrisch leitende Verbindung der Anschlussenden eines ersten Satzes an elektrischen Flächenleiterbahnen mit dem ersten elektrisch leitfähigen Leiterband auf. Das zweite Leiterband weist eine Vielzahl an Kontaktstellen für die elektrisch leitende Verbindung der Anschlussenden eines zweiten Satzes an elektrischen Flächenleiterbahnen mit dem zweiten elektrisch leitfähigen Leiterband auf. Eine Kontaktstelle kann beispielsweise bereitgestellt sein durch eine elektrisch leitfähige Oberfläche, insbesondere an einer Rückseite, der Kontaktleiste. Die Kontaktleiste kann eine Rückseite und eine Vorderseite haben, wobei die insbesondere flächige Rückseite dazu ausgelegt und eingerichtet ist, in einen Berührkontakt mit dem Trägersystem und/oder einer Gebäudewand bringbar oder gebracht zu sein. Die Kontaktleiste kann eine Haupterstreckung in der transversalen Richtung aufweisen, die wesentlich, insbesondere wenigstens 5 mal oder wenigstens 10 mal größer ist als eine Erstreckung der Kontaktleiste in der longitudinalen Richtung und/ oder in einer Tiefen-Richtung quer zur longitudinalen Richtung und zur transversalen Richtung. Die Erstreckung der Kontaktleiste in der longitudinalen Richtung, insbesondere der Vertikalrichtung, ist vorzugsweise größer als die Erstreckung Kontaktleiste in der Tiefen-Richtung, insbesondere der sekundären Horizontalrichtung. Bei einem Gebäudeoberflächenfunktionssystem kann die transversale Haupterstreckungsrichtung der Kontaktleiste einer primären Horizontalrichtung entsprechen. Die elektrischen Flächenleiterbahnen des ersten und des zweiten Satzes an elektrischen Flächenleiterbahnen sind jeweils im Wesentlichen alternierend zueinander angeordnet. Insbesondere sind an oder in dem Trägersystem, insbesondere der Trägerlage, die Flächenleiterbahnen des ersten Satzes und die Flächenleiterbahnen des zweiten Satzes in der transversalen Richtung alternierend zueinander vorgesehen. Vorzugsweise sind entlang der transversalen Richtung, insbesondere in dem Anschlussbereich und/oder entlang der Longitudinalrandkante des Trägersystems, insbesondere der Trägerlage, abwechselnd Flächenleiterbahnen des ersten Satzes und des zweiten Satzes angeordnet. Es sei klar, dass die Flächenleiterbahnen des ersten Satzes und des zweiten Satzes strukturell gleich sein können. Die Zuordnung der Flächenleiterbahnen zu entweder dem ersten Satz oder dem zweiten Satz kann vorzugsweise entsprechend der Verbindung oder Verwendbarkeit der jeweiligen Flächenleiterbahnen des ersten Satzes zu dem ersten Leiterband und der jeweiligen Flächenleiterbahnen des zweiten Satzes zu dem zweiten Leiterband erfolgen. Vorzugsweise sind die Flächenleiterbahnen des ersten Satzes elektrisch mit dem ersten Leiterband sowie gegebenenfalls dem ersten Pol verbunden oder verbindbar, insbesondere durch eine räumlich korrespondierende Anordnung der Kontaktstellen des ersten Leiterbandes zu den Anschlussenden der Flächenleiterbahnen des ersten Satzes. Vorzugsweise sind die Flächenleiterbahnen des zweiten Satzes elektrisch mit dem zweiten Leiterband sowie gegebenenfalls dem zweiten Pol verbunden oder verbindbar, insbesondere durch eine räumlich korrespondierende Anordnung der Kontaktstellen des ersten Leiterbandes zu den Anschlussenden der Flächenleiterbahnen des ersten Satzes.

Von besonderem Vorteil bei der vorliegenden Erfindung ist auch, dass das Anbringen des erfindungsgemäßen Oberflächenfunktionssystems nicht zwangsläufig den Einsatz von Elektrikern oder von geschultem Fachpersonal im Elektrikbereich erfordert, sondern auch von z.B. Personal aus dem Malerhandwerk oder Trockenbau vorgenommen werden kann.

Das erfindungsgemäße Oberflächenfunktionssystem, insbesondere für eine Gebäudewand und/oder einen Akustikkörper, ist auch großtechnisch einfach und kostengünstig herstellbar, kann einfach auf verschiedenste Gegebenheiten angepasst, beispielsweise eingekürzt, werden und stellt eine sichere und einfache elektrische Kontaktierbarkeit bereit.

Eine besonders geeignete Ausführungsform eines erfindungsgemäßen Oberflächenfunktionssystems umfasst ferner mindestens ein Niedervoltbereich-Netzteil, verbunden oder verbindbar mit der elektrischen Kontaktleiste. Das Niedervoltbereich-Netzteil kann als Gleichspannungsquelle für das Oberflächenfunktionssystem, insbesondere Gebäudeoberflächenfunktionssystem, agieren. Vorzugsweise ist das Niedervoltbereich-Netzteil dazu ausgelegt und eingerichtet, Strom, insbesondere Wechselstrom, mit einer Netzspannung von etwa 230 V zu empfangen. Alternativ oder zusätzlich ist das Niedervoltbereich-Netzteil dazu ausgelegt und eingerichtet, für das erfindungsgemäße Oberflächenfunktionssystem Strom, insbesondere Gleichstrom, im Niedervoltbereich mit insbesondere nicht mehr als 48 V, vorzugsweise nicht mehr als 24 V, besonders bevorzugt nicht mehr als 12 V bereitzustellen.

Eine andere Ausführungsform eines erfindungsgemäßen Oberflächenfunktionssystems, insbesondere eines Gebäudeoberflächenfunktionssystems, die mit den vorigen kombinierbar ist, umfasst ferner mindestens eine Abdeckleiste, insbesondere eine Fuß- und/oder Deckenleiste. Bevorzugt ist die Kontaktleiste, insbesondere integraler, Bestandteil der Abdeckleiste, insbesondere Fuß- und/oder Deckenleiste. Alternativ kann die Abdeckleiste lösbar mit der Kontaktleiste verbindbar sein. Vorzugsweise ist die Transversalerstreckung einer Abdeckleiste größer als die Transversalerstreckung der korrespondierenden Kontaktleiste. Die Kontaktleiste kann von einer insbesondere längeren Abdeckleiste verdeckbar sein. Die Abdeckleiste kann als ein Profilkörper gebildet sein, der sich in transversaler Richtung, insbesondere parallel, erstreckende Aufnahmerinnen für das erste Leiterband und das zweite Leiterband aufweist. Die Aufnahmerinnen können insbesondere parallel zueinander in longitudinaler Richtung, insbesondere vertikal, versetzt in der Abdeckleiste angeordnet sein. In der Abdeckleiste kann mindestens ein Kabelschaft für ein Netzwerkkabel oder dergleichen vorgesehen sein. An der raumseitigen Vorderseite der Abdeckleiste kann eine Blende vorgesehen sein, die dazu ausgelegt und eingerichtet ist, die Aufnahmerinnen zu überdecken. An der gebäudewandseitigen Rückseite der Abdeckleiste können Öffnungen vorgesehen sein, durch welche das jeweilige Leiterband aus den Aufnahmerinnen an die rückseitige Oberfläche an der Abdeckleisten-Rückseite freigelegt ist, insbesondere hervorsteht. Die Kontaktstellen des ersten Leiterbandes und/oder des zweiten Leiterbandes sind an der Rückseite der Abdeckleiste angeordnet.

Es kann bevorzugt sein, dass die Rückseite der Abdeckleiste mindestens abschnittsweise magnetisch ist und/oder dass die Abdeckleiste mit wenigstens einer magnetischen Haltekomponente ausgestattet ist. Vorzugsweise sind die Kontaktstellen des ersten Leiterbandes in Relation zu den Kontaktstellen des zweiten Leiterbandes entlang der Abdeckleiste in transversaler Richtung, insbesondere horizontal, versetzt angeordnet. Alternativ oder zusätzlich sind die Kontaktstellen des ersten Leiterbandes in Relation zu den Kontaktstellen des zweiten Leiterbandes entlang der Abdeckleiste in longitudinale Richtung, insbesondere vertikal, versetzt angeordnet.

Bei einer Ausführungsform eines erfindungsgemäßen Oberflächenfunktionssystems, vorzugsweise mit Abdeckleiste, insbesondere Fuß- und/oder Deckenleiste, ist die Abdeckleiste und/oder die Kontaktleiste magnetisch oder magnetisierbar ausgestaltet. Vorzugsweise ist die Seite der Kontaktleiste, an welcher die Kontaktstellen vorgesehen sind, insbesondere die wandseitige Rückseite, magnetisch oder magnetisierbar ausgestaltet. Eine magnetisierbare oder magnetische Kontakt- oder Abdeckleiste kann insbesondere mit der unten beschriebenen Ausführungsform eines Oberflächenfunktionssystems mit einer magnetisierbaren Lage kombinierbar sein.

Gemäß einer bevorzugten Ausführungsform eines erfindungsgemäßen Oberflächenfunktionssystems, insbesondere eines Gebäudeoberflächenfunktionssystems, umfasst das Trägersystem eine Gipskartonplatte, eine Dämmstoffplatte, eine Putzbeschichtung, eine Spachtelschicht, eine Farbschicht, eine Grundierungsschicht, eine Holzplatte, eine Kunststofffolie und/oder eine Vlieslage insbesondere basierend auf Kunststoff-, Cellulose- oder Glasfaservliesen. Alternativ oder zusätzlich kann die Trägerlage eine Tapete, insbesondere auf Basis von Cellulose und/oder Papier, umfassen oder darstellen. Insbesondere stellt das Trägersystem eine Gipskartonplatte, eine Dämmstoffplatte, eine Putzbeschichtung, eine Spachtelschicht, eine Farbschicht, eine Grundierungsschicht, eine Holzplatte, eine Kunststofffolie und/oder eine Vlieslage insbesondere basierend auf Kunststoff-, Cellulose- oder Glasfaservliesen dar. Vorzugsweise ist das Trägersystem, insbesondere die Trägerlage, bahnförmig und flexibel und/ oder aufrollbar bzw. entrollbar. Beispielsweise kann das Trägersystem eine Tapete umfassen oder darstellen. Bei einem bahnförmigen Trägersystem kann es bevorzugt sein, dass die longitudinale Richtung der elektrisch leitfähigen Leiterbänder zu der Bahnrichtung des Trägersystems korrespondiert, insbesondere parallel zur Bahnrichtung ist, oder dass die longitudinale Richtung der elektrisch leitfähigen Leiterbänder quer, insbesondere orthogonal, zur Bahnrichtung des Trägersystems ausgerichtet ist.

Erfindungsgemäß sind die Anschlussenden der elektrischen Flächenleiterbahnen des ersten Satzes an elektrischen Flächenleiterbahnen reversibel mit den Kontaktstellen des ersten elektrisch leitfähigen Leiterbandes verbindbar oder verbunden. Auch die Anschlussenden der elektrischen Flächenleiterbahnen des zweiten Satzes an elektrischen Flächenleiterbahnen sind reversibel mit den Kontaktstellen des zweiten elektrisch leitfähigen Leiterbandes verbindbar oder verbunden. Die Anordnung und Größe der Kontaktstellen ist vorzugsweise auf die Anordnung und Größe der elektrisch leitfähigen Flächenleiterbahnen im Bereich der Anschlussenden abgestimmt. Zu diesem Zweck kann vorgesehen sein, dass der Abstand benachbarter Kontaktstellen der Kontaktleiste in der transversalen Richtung zu dem Abstand der Anschlussenden in der transversalen Richtung korrespondiert. Insbesondere kann der Abstand, insbesondere aller, benachbarter Kontaktstellen der Kontaktleiste im Wesentlichen der Summe aus der Transversalbreite einer elektrischen Flächenleiterbahn und der Transversalabstand der leiterfreien Fläche abzüglich der transversalen Ausdehnung einer einzelnen Kontaktstelle entsprechen. Zwischen den alternierenden Kontaktstellen des ersten und des zweiten Leiterbandes ist in transversaler Richtung jeweils dieser Abstand ausgebildet. Der Abstand benachbarter Kontaktstellen desselben ersten oder zweiten Leiterbands entspricht vorzugsweise dem Doppelten des Abstands benachbarter Kontaktstellen. Die transversale Ausdehnung der Kontaktstellen liegt vorzugsweise im Bereich 0,1 mm bis 5 mm, insbesondere 0,25 mm bis 1,5 mm, vorzugsweise im Bereich 0,5 mm bis 1 mm. Die Kontaktstellen können als von der Kontaktleiste hervorstehende Wölbungen und/oder Stifte gebildet sein. Es kann bevorzugt sein, dass die Ausdehnung der Kontaktstellen in der transversalen Richtung und die Transversalbreite der elektrisch leitfähigen Flächenleiterbahnen im Wesentlichen gleichgroß sind oder dass die Ausdehnung der Kontaktstellen kleiner ist als die Transversalbreite.

Bei einer besonders bevorzugten Ausführungsform, die mit den vorigen kombinierbar ist, ist das Trägersystem, insbesondere die Trägerlage, magnetisierbar ausgestaltet. Es kann bevorzugt sein, dass das Trägersystem, insbesondere die Trägerlage, mit magnetisierbaren Materialien, insbesondere ferri- und/oder ferromagnetischen Materialien, z.B. Magnetit, ausgestattet ist. Erfindungsgemäß weist das Oberflächenfunktionssystem ferner mindestens eine magnetisierbare Haltelage auf, die vorderseitig an dem Trägersystem, insbesondere der Trägerlage, vorliegt. Diese Ausführungsformen können insbesondere mit anderen oben oder unten beschriebenen Ausführungsformen kombinierbar sein, bei denen die Kontaktleiste oder gegebenenfalls die Abdeckleiste, sowie gegebenenfalls ein Funktionsobjekt magnetisch oder magnetisierbar eingerichtet ist. Ein Oberflächenfunktionssystem mit einer magnetischen oder magnetisierbaren Haltelage und/oder magnetischen oder magnetisierbaren Trägersystem hat zum einen den Vorteil, dass beispielsweise in Mietwohnungen beschädigungsfrei mittels magnetischer Haftung Objekte an einer Gebäudeoberfläche, wie einer Gebäudewand oder Gebäudedecke, anbringbar sind. Ein besonderer Vorteil dieser Ausführungsform des erfindungsgemäßen Oberflächenfunktionssystems kann darin gesehen werden, dass mithilfe einer Magnetkraft beispielsweise zwischen der Kontaktleiste und dem Trägersystem eine sichere mechanische Kontaktierung zwischen den Leiterbändern und den dazu korrespondierenden Flächenleiterbahnen unterstützt werden kann. Auch elektrische Funktionsobjekte, die vorzugsweise mittels des Oberflächenfunktionssystems mit Strom versorgt sein können, können elektrische Kontakte aufweisen, die unterstützt durch eine magnetische Kraftpaarung zwischen dem Trägersystem und dem Funktionsobjekt eine sichere mechanische Verbindung mit den Flächenleiterbahnen eingehen können. Gemäß einer besonders bevorzugten Ausführungsform umfasst die magnetisierbare Haltelage ferri- und/oder ferromagnetische Materialien, die insbesondere Magnetit enthalten oder aus Magnetit bestehen.

Die magnetisierbare Haltelage oder die magnetisierbare Trägerlage kann partikelförmige magnetisierbare Materialien enthalten, insbesondere ferri- und/oder ferromagnetische Materialien. Unter diesen partikelförmigen magnetisierbaren Materialien sind Ferrite, insbesondere Magnetit, Eisenpulver, insbesondere ferromagnetisches Eisenpulver und/oder kohlenstoffhaltiges Eisenpulver, und beliebigen Mischungen hiervon besonders bevorzugt. Unter den genannten partikelförmigen magnetisierbaren Materialien wird besonders bevorzugt auf Magnetit zurückgegriffen. Solche partikelförmigen magnetisierbaren Materialien haben sich als besonders geeignet für die Lösung der der Erfindung zugrunde liegenden Aufgabe erwiesen, die über eine durchschnittliche Partikelgröße D50 im Bereich von 10 bis 100 µm, bevorzugt im Bereich von 20 bis 30 µm, verfügen. Die durchschnittliche Partikelgröße D50 kann gemäß DIN ISO 9276-1:2004-09 (Darstellung der Ergebnisse von Partikelgrößenanalysen - Teil 1: grafische Darstellung) und ISO 9276-2:2014-05 (Darstellung der Ergebnisse von Partikelgrößenanalysen - Teil 2: Berechnung von mittleren Partikelgrößen/-durchmessern und Momenten aus Partikelgrößenverteilungen) ermittelt werden. Für die Bestimmung der D50-Werte kann dabei auf sogenannte Laser Scattering Particle Size Distribution Analyser, wie von der Firma Horiba unter der Gerätebezeichnung "LA 950 V2" erhältlich, zurückgegriffen werden.

Erfindungsgemäß ist vorgesehen, dass die magnetisierbare oder magnetische Haltelage eine Putzbeschichtung, eine Spachtelschicht, eine Farbschicht, eine Grundierungsschicht und/oder eine Vlieslage, insbesondere basierend auf Kunststoff-, Cellulose- oder Glasfaservliesen, umfassen oder darstellen, die jeweils mit magnetisierbaren Materialien, insbesondere ferri- und/oder ferromagnetischen Materialien, z.B. Magnetit, ausgestattet ist.

Bei einer bevorzugten Ausführungsform des erfindungsgemäßen Oberflächenfunktionssystems mit einem Netzteil und gegebenenfalls eine Abdeckleiste kann das Netzteil ein Bestandteil der Kontaktleiste, insbesondere der Abdeckleiste, sein. Alternativ kann das Netzteil in eine Putzbeschichtung oder ähnliches eingebettet oder als Bestandteil darin integriert sein.

Vorzugsweise kann bei einer Ausführungsform vorgesehen sein, dass die Kontaktleiste einkürzbar ist, insbesondere vermittels vorgegebener Schwächungsareale, beispielsweise mithilfe von Einkerbungen. Als einkürzbar kann im Allgemeinen ein Strang-, Profil- und/oder bahnförmiges Material bezeichnet sein, von dem quer zu seiner Haupterstreckungsrichtung (Bahnrichtung) Material-Abschnitte abgetrennt, also vereinzelt werden können, beispielsweise um an bestimmte dimensionale Vorgaben etwa eines Gebäudes, wie eine Wandbreite oder -höhe, anpassbar zu sein. Bei der Kontaktleiste, die insbesondere auch als Abdeckleiste realisierbar ist, entspricht die Haupterstreckungsrichtung vorzugsweise der transversalen Richtung. Die Schwächungsareale können Sollbruchstellen o. ä. realisieren, an denen eine einfache, funktionserhaltende Unterteilbarkeit realisierbar ist, um eine einfache Handhabung bei besonders niedrigem Risiko von Beschädigungen, insbesondere Kurzschlüssen zwischen dem ersten und dem zweiten Leiterband, zu gewährleisten.

Bei einer anderen Ausführungsform, die mit den vorigen kombinierbar ist, verfügt die Vielzahl an Flächenleiterbahnen über eine im Wesentlichen einheitliche Transversalbreite. Insbesondere kann die Vielzahl an Flächenleiterbahnen auch über im Wesentlichen einheitliche Transversalabstände zwischen benachbarten Flächenleiterbahnen verfügen. Alternativ oder zusätzlich verfügt die Vielzahl an Flächenleiterbahnen über eine im Wesentlichen einheitliche longitudinale Ausdehnung, die vorzugsweise einer Raumhöhe, -länge oder -breite entsprechen kann. Außerdem kann es bevorzugt sein, dass die Vielzahl an benachbarten Flächenleiterbahnen im Wesentlichen parallel verlaufen. Insbesondere kann mithilfe des Trägersystems, insbesondere der Trägerlage, eine regelmäßige und/oder gleichmäßige Anordnung der Leiterbahnen festgelegt sein.

Gemäß einer bevorzugten Ausführungsform sind, insbesondere im Bereich des Trägersystems, die Vielzahl an benachbarten Flächenleiterbahnen jeweils durch eine leiterfreie Fläche voneinander getrennt, insbesondere elektrisch isoliert. Insbesondere sind, vorzugsweise im Bereich des Trägersystems, die elektrischen Flächenleiterbahnen des ersten Satzes von den elektrischen Flächenleiterbahnen des zweiten Satzes getrennt, insbesondere elektrisch isoliert. Insbesondere sind, vorzugsweise im Bereich des Trägersystems, die elektrischen Flächenleiterbahnen des ersten Satzes voneinander getrennt, insbesondere elektrisch isoliert. Alternativ oder zusätzlich sind, vorzugsweise im Bereich des Trägersystems, die elektrischen Flächenleiterbahnen des zweiten Satzes voneinander getrennt, insbesondere elektrisch isoliert. Vorzugsweise ist eine Vielzahl an Flächenleiterbahnen insbesondere sämtliche Flächenleiterbahnen, im Bereich des Trägersystems elektrisch voneinander separiert, insbesondere isoliert. Vorzugsweise können elektrische Verbindungen zwischen, insbesondere benachbarten, Flächenleiterbahnen geschlossen werden durch quer zu den Flächenleiterbahnen angeordnete Elektronikkomponenten, beispielsweise das erste Leiterband und/oder das zweite Leiterband und/oder einen Stromaufnehmer. Vorzugsweise ist das Trägersystem frei von elektrischen Querverbindungen zwischen nebeneinander, insbesondere benachbart, angeordneten Flächenleiterbahnen. Da die Flächenleiterbahnen, insbesondere im Bereich des Trägersystems, voneinander getrennt sind, ist das erfindungsgemäße Oberflächenfunktionssystem besonders gut auf verschiedene räumliche Gegebenheiten anpassbar, beispielsweise an unterschiedliche Wandformen, Raumhöhen und so weiter. Insbesondere kann durch das Ausgliedern einer elektrischen Verbindung verschiedener Flächenleiterbahnen des erfindungsgemäßen Oberflächenfunktionssystems in zusätzliche Komponenten, wie die Kontaktleiste, ein Funktionsobjekt und/oder einen Stromaufnehmer, erreicht werden, dass die Konsequenzen im Falle einer Beschädigung oder Fehlmontage des Oberflächenfusionssystems auf einen kleinen Bereich beschränkt sein können, ohne die allgemeine Funktionstüchtigkeit des gesamten Oberflächenfunktionssystems zu beeinträchtigen.

Bei einer Weiterbildung eines erfindungsgemäßen Oberflächenfunktionssystems mit leiterfreien Flächen, definiert die leiterfreie Fläche jeweils einen Transversalabstand zwischen zwei benachbarten Flächenleiterbahnen. Die Flächenleiterbahnen weisen jeweils eine Transversalbreite zwischen zwei benachbarten leiterfreien Flächen auf. Die Transversalbreite ist wenigstens so groß wie der Transversalabstand, insbesondere für wenigstens 5, vorzugsweise wenigstens 10, besonders bevorzugt mehr als 10 oder alle Flächenleiterbahnen des Oberflächenfunktionssystems. Insbesondere ist die Transversalbreite größer als der Transversalabstand, insbesondere für wenigstens 5, vorzugsweise wenigstens 10, besonders bevorzugt mehr als 10 oder alle Flächenleiterbahnen des Oberflächenfunktionssystems. Zusätzlich oder alternativ kann ein Transversalmodul definiert sein als die Summe aus der Transversalbreite einer elektrischen Flächenleiterbahn und dem zweifachen eines Transversalabstands der, insbesondere dazu benachbarten, leiterfreien Fläche.

Gemäß einer anderen Weiterbildung, die mit der vorigen kombinierbar ist, liegt der Transversalabstand im Bereich von wenigstens 1 mm bis 10 mm, insbesondere 2 mm bis 5 mm, vorzugsweise bei etwa 3 mm. Alternativ oder zusätzlich liegt die Transversalbreite im Bereich von wenigstens 1 mm bis 50 mm, insbesondere 15 mm bis 35 mm, vorzugsweise bei etwa 25 mm.

Bei einer weiteren Weiterbildung ist vorgesehen, dass die benachbarten Flächenleiterbahnen der Vielzahl an benachbarten Flächenleiterbahnen im Wesentlichen den gleichen seitlichen Abstand (Transversalabstand) voneinander aufweisen und/oder dass die leiterfreien Flächen zwischen benachbarten Flächenleitern der Vielzahl an benachbarten Flächenleitern im Wesentlichen über eine einheitliche Breite verfügen. Es kann bevorzugt sein, dass das erfindungsgemäße Oberflächenfunktionssystem, das im Bereich einer Querbreite von wenigstens 20 cm, insbesondere wenigstens 50 cm, vorzugsweise wenigstens 75 cm, besonders bevorzugt über die vollständige Querbreite des Oberflächenfunktionssystems, quer, vorzugsweise orthogonal, zur Longitudinalrichtung mindestens eine longitudinale elektrisch Flächenleiterbahnen pro 10 cm Querbreite, insbesondere pro 5 cm Querbreite, vorzugsweise pro 3 cm Querbreite, des Oberflächenfunktionssystems umfasst.

Ein erfindungsgemäßes Oberflächenfunktionssystem umfasst gemäß einer anderen Ausführungsform, die mit den vorigen kombinierbar ist, ferner mindestens einen Stromaufnehmer für einen elektrischen Verbraucher, umfassend mindestens zwei oder drei, bevorzugt mindestens fünf und besonders bevorzugt genau fünf elektrisch leitende Kontaktelemente, ausgelegt und eingerichtet, um mit zwei benachbarten elektrischen Flächenleiterbahnen wechselzuwirken. Insbesondere sind die Kontaktelemente des Stromaufnehmers derart auf die Flächenleiterbahnen abgestimmt, dass wenigstens zwei der Kontaktelemente desselben Stromaufnehmers mit verschiedenen, insbesondere benachbarten, Flächenleiterbahnen, vorzugsweise einerseits des ersten Satzes an elektrischen Flächenleiterbahnen und andererseits des zweiten Satzes an elektrischen Flächenleiterbahnen, in Kontakt bringbar sind. Zu diesem Zweck können beispielsweise die Kontaktelemente bezüglich ihrer Größe, Form und Abstand abgestimmt sein auf Größe, Form und Abstand der Flächenleiterbahnen. Vorzugsweise ist wenigstens ein erstes der mehreren Kontaktelemente mit wenigstens einer Flächenleiterbahn des ersten Satzes in Kontakt bringbar und wenigstens ein zweites der mehreren Kontaktelemente mit wenigstens einer Flächenleiterbahn des zweiten Satzes in Kontakt bringbar, insbesondere unabhängig von der Lage und Ausrichtung des Stromaufnehmers.

Bei einer Weiterbildung eines Oberflächenfunktionssystems stellt der Stromaufnehmer für den elektrischen Verbraucher einen Kontaktierungsadapter enthaltend eine Gleichrichterschaltung dar. Die Gleichrichterschaltung ist vorzugsweise dazu ausgelegt und eingerichtet, die Stromversorgung des Verbrauchers mit einem vorbestimmten Gleichstrom zu gewährleisten, unabhängig davon, welches der mehreren Kontaktelemente mit einer Flächenleiterbahnen des ersten Satzes und welches andere der mehreren Kontaktelemente mit einer Flächenleiterbahn des zweiten Satzes an Flächenleiterbahnen in elektrischer Kontaktverbindung steht.

Bei einer Weiterbildung, die mit den anderen kombinierbar ist, umfasst der Stromaufnehmer für mindestens einen elektrischen Verbraucher wenigstens eine magnetische Haltekomponente. Insbesondere ist der Stromaufnehmer mit einer magnetischen Rückseite ausgestattet, die der Haltelage zugewandt oder zuwendbar ist. Mithilfe der magnetischen Haftkomponente kann die Befestigung des Stromaufnehmers an dem Trägersystem verbessert und insbesondere ein Durchdringen der Flächenleiterbahnen mit den Kontakten des Stromaufnehmers sichergestellt werden.

Bei einem Oberflächenfunktionssystem gemäß einer anderen Weiterbildung, die mit den übrigen kombinierbar ist, umfasst der Stromaufnehmer wenigstens zwei Anschlussaufnahmen, wie Anschlussklemmen, die dazu ausgelegt und eingerichtet sind, je wenigstens eine elektrische Leitung eines elektrischen Verbrauchers aufzunehmen. Beispielsweise kann ein solcher Stromaufnehmer vorgesehen sein, um eine konventionelle Wand- oder Deckenlampe mit elektrischer Energie zu versorgen, indem dem die elektrischen Versorgungsleitungen der konventionellen Lampe mit den Anschlussklemmen oder anderen Anschlussaufnahmen, beispielsweise nach Art einer Lüsterklemme, verbunden werden.

Gemäß einer anderen Weiterbildung, die mit der vorigen kombinierbar ist, liegen mehrere, insbesondere alle, der Kontaktelemente in einem Kreisring, insbesondere auf einem Kreisumfang. Alternativ oder zusätzlich kann vorgesehen sein, dass mehrere, insbesondere alle, benachbarten Kontaktelemente (desselben Stromaufnehmers) im Wesentlichen gleich weit voneinander entfernt sind. Die Abstände benachbarter Kontaktelemente können um weniger als ±20%, insbesondere um weniger als ±10%, vorzugsweise um weniger als ±5%, voneinander abweichen. Insbesondere bilden mehrere, vorzugsweise alle, der Kontaktelemente ein bevorzugt gleichseitiges Vieleck. Es sei klar, dass die das Vieleck bildenden Kontaktelemente an den Ecken des Vielecks angeordnet sind. Vorzugsweise kann wenigstens ein oder genau ein Kontaktelement innerhalb des Vielecks, insbesondere im Mittelpunkt des Vielecks, angeordnet sein.

Gemäß einer weiteren Weiterbildung, die mit den vorigen kombinierbar ist, hat mindestens ein Paar an Kontaktelementen desselben Stromaufnehmers einen Kontaktabstand zueinander. Es sei klar, dass das Paar an Kontaktelementen bestehen kann aus einem ersten Kontaktelemente verbindbar oder verbunden mit einer Flächenleiterbahn des ersten Satzes an Flächenleiterbahnen und einem zweiten Kontaktelement verbindbar oder verbunden mit einer Flächenleiterbahn des zweiten Satzes an Flächenleiterbahnen. Ferner sei klar, dass der Stromaufnehmer beispielsweise mit einer Vielzahl an, beispielsweise drei, Kontaktelementen ausgestaltet sein kann, die permutationsartig als mehrere Paare, beispielsweise drei Paare, kombinierbar sind. Bei einem anderen Beispiel eines Stromaufnehmers mit fünf Kontaktelementen können beispielsweise die Kontaktelemente in zehn Paaren permutationsartig kombinierbar sein. Der Kontaktabstand ist vorzugsweise größer als die Summe aus der Transversalbreite einer elektrischen Flächenleiterbahn und dem Transversalabstand der leiterfreien Fläche. Insbesondere ist der Kontaktabstand kleiner als die Summe aus der doppelten Transversalbreite einer elektrischen Flächenleiterbahn und dem Transversalabstand der leiterfreien Fläche. Vorzugsweise kann der Kontaktabstand im Wesentlichen dem Transversalmodul entsprechen, wobei insbesondere das Transversalmodul geringfügig größer als der Kontaktabstand bemessen sein kann, um unter Berücksichtigung der Querschnittsgröße der Kontaktelemente eine kurzschlusssichere Anbringbarkeit des Stromaufnehmers zu gewährleisten und/oder um die Wahrscheinlichkeit zu minimieren, dass beim Anbinden des Stromaufnehmers an das Trägersystem mit den Flächenleiterbahnen kein Stromkreis geschlossen wird. Insbesondere kann von im Wesentlichen gleichen Kontaktabstand und Transversalmodul ausgegangen werden, wenn Kontaktabstand sich um nicht mehr als ±20%, insbesondere um nicht mehr als ±10%, vorzugsweise um nicht mehr als ±5% von dem Transversalmodul unterscheidet. Es kann bevorzugt sein, dass der Kontaktabstand wenigstens so groß ist wie das Transversalmodul. Besonders bevorzugt ist der Kontaktabstand im Vergleich zum Transversalmodul 0% bis 20% größer, insbesondere 0,1 % bis 10% größer, vorzugsweise 0,5 % bis 5% größer.

Gemäß einer bevorzugten Weiterbildung sind die Kontaktelemente nadelförmig ausgestaltet, insbesondere mit einem konisch geformtem Einsteckende. Insbesondere können wenigstens ein, wenigstens zwei oder alle Kontaktelement eines Stromaufnehmers nadelförmig sein. Vorzugsweise ist die Nadelform derart formangepasst an das Trägersystem, insbesondere die Trägerlage, und die Flächenleiterbahnen, dass die Kontaktelemente die Flächenleiterbahnen durchdringen können. Alternativ oder zusätzlich können die Kontaktelemente stiftförmig ausgestaltet sein, insbesondere mit einem Zylinderabschnitt oder aus einem Zylinderabschnitt bestehen. Insbesondere kann vorgesehen sein, dass die Kontaktelemente nadelförmig ausgestaltet sind, mit einem Zylinderabschnitt und einem konisch geformten Ende. Die Kontaktelemente sind vorzugsweise zum Durchdringen der Leiterbahnen ausgelegt und eingerichtet. Vorzugsweise weisen die Kontaktelemente eine elektrisch leitfähige Umfangsfläche auf.

Insbesondere können gemäß einer Weiterbildung die Kontaktelemente, insbesondere alle Kontaktelemente eines oder mehrerer Stromaufnehmer, eine Querschnittsbreite aufweisen, die kleiner ist als der Transversalabstand. Insbesondere kann die Querschnittsbreite im Wesentlichen der Hälfte des Transversalabstands entsprechen. Alternativ oder zusätzlich ist die Querschnittsbreite wenigstens 0,5 mm, vorzugsweise mindestens 1 mm, kleiner als der Transversalabstand. Vorzugsweise liegt die Querschnittsbreite im Bereich 0,25 mm bis 1,5 mm, insbesondere im Bereich 0,4 mm bis 1 mm und bevorzugt im Bereich von 0,5 mm bis 0,8 mm.

Alternativ oder zusätzlich kann gemäß einer Weiterbildung vorgesehen sein, dass die Kontaktelemente eine Kontaktelementlänge, beispielsweise eine Nadellänge, aufweisen, die größer ist als eine Bahndicke der Flächenleiterbahnen und/oder größer ist als eine Systemdicke des Trägersystems, insbesondere der Trägerlage. Insbesondere ist die Kontaktelementlänge wenigstens so groß wie die Summe von Bahndicke und Systemdicke.

Gemäß einer Ausführungsform umfasst das Oberflächenfunktionssystem ferner mindestens eine Dekorbeschichtung, die vorderseitig an dem Trägersystem, insbesondere an der Trägerlage, oder an der magnetisierbaren oder magnetischen Haltelage vorliegt.

Gemäß einer Ausführungsform sind die mindestens eine elektrische Flächenleiterbahn, insbesondere die Vielzahl an, insbesondere longitudinalen, elektrischen Flächenleiterbahnen ausgewählt aus der Gruppe bestehend aus metallischen Flächenleitern, insbesondere aus Kupfer- und/oder Aluminiumfolie, Bahnen aus, insbesondere mittels Druckverfahren aufgebrachter, elektrisch leitfähiger Tinte, leitfähigen Polymercompounds und Carbonfaser-basierten Systemen.

Bei einer bevorzugten Ausführungsform eines erfindungsgemäßen Oberflächenfunktionssystems umfasst dieses ferner mindestens ein Funktionsobjekt, das mit einer magnetisch aktiven Rückseite ausgestattet ist. Das mindestens eine Funktionsobjekt kann beispielsweise ein passives Funktionsobjekt sein, wie ein Bild, einen Bilderrahmen, eine Magnethalterung, ein Whiteboard, eine Tafel, ein Regal, einen Wandklapptisch, insbesondere enthaltend, ein Dekorationselement, eine Projektionsfläche, einen Spiegel, einen Kerzenhalter, einen Gardinenhalter, Holzpaneele, Bilderleisten, Fliesen, Schienen, eine Vase, eine Ordnungsleiste, einen Ordnungshelfer oder ein Hängeschrank, eine Dämmplatte oder eine Akustikplatte. Das mindestens eine Funktionsobjekt kann beispielsweise ein aktives Funktionsobjekt sein, wie eine USB-Ladestation, eine Wanduhr, einen Bildschirm, einen Deko-Kamin, eine Sockelleiste, eine Lampe, einen Hausautomationsschalter, einen Lautsprecher, ein Radio, ein ActiveNoise Cancelling-System, ein Heizelement, ein Rauchmelder, GPS-Tracker, Flüssigkeitsspender, wie ein Seifenspender oder Desinfektionsmittelspender, und/oder ein Sensor, wie ein Raumsensor, beispielsweise ein Temperatursensor, Geräuschsensor, Helligkeitssensor, Bewegungssensor, Hygrometer, Personensensor, Vibrationssensor. Das Funktionsobjekt kann mehrere passive und/oder aktive Funktionsobjekte umfassen. Das mindestens eine aktive Funktionsobjekt umfasst vorzugsweise wenigstens einen elektrischen Verbraucher, der durch das Oberflächenfunktionssystem mit Strom im Niedervolt-Bereich versorgbar oder versorgt ist. Vorzugsweise umfasst das Funktionsobjekt genau einen oder mehrere Stromaufnehmer mit mehreren Kontaktelementen, wie oben beschrieben. Insbesondere kann das Funktionsobjekt mindestens einen elektrischen Verbraucher mit Stromaufnehmer umfassen.

Die Erfindung betrifft auch die Verwendung des oben beschriebenen Oberflächenfunktionssystems für die flächige Stromversorgung von Niedervolt-Applikationen von mindestens einem Stromaufnehmer für einen elektrischen Verbraucher, umfassend mindestens zwei oder drei, bevorzugt mindestens fünf und besonders bevorzugt genau fünf, elektrisch leitende Kontaktelemente, ausgelegt und eingerichtet, um mit zwei benachbarten elektrischen Flächenleiterbahnen wechselzuwirken.

Die Erfindung betrifft ferner eine Gebäudewand oder -decke, die mindestens ein oben beschriebenes Gebäudeoberflächenfunktionssystem enthält. Vorzugsweise ist die Gebäudewand oder -decke Teil eines Fertighauses. Alternativ kann die Gebäudewand oder -decke ausgelegt und eingerichtet sein zur Verwendung in einem Fertighaus.

Alternativ oder zusätzlich kann die Erfindung einen Akustikkörper, insbesondere eine Akustikwand, betreffen, die mindestens ein erfindungsgemäßes Oberflächenfunktionssystem wie oben beschrieben enthält.

Weitere Eigenschaften, Merkmale und Vorteile der Erfindung werden durch die folgende Beschreibung einer bevorzugten Ausführungsform der Erfindung anhand der beiliegenden Zeichnung deutlich, in denen zeigt:
- Figur 1: eine schematische Darstellung einer exemplarischen Ausführungsform eines erfindungsgemäßen Gebäudeoberflächenfunktionssystems;
- Figur 2: eine perspektivische Darstellung einer Kontaktleiste;
- Figur 3: eine schematische Rückansicht einer Kontaktleiste;
- Figur 4: eine schematische Darstellung einer exemplarischen Ausführungsform eines erfindungsgemäßen Oberflächenfunktionssystems mit zwei unterschiedlichen Stromaufnehmern;
- Figur 5: eine schematische Darstellung einer exemplarischen Ausführungsform eines erfindungsgemäßen Oberflächenfunktionssystems mit einem Stromaufnehmer;
- Figur 6: eine schematische Schnittansicht einer exemplarischen Ausführungsform eines erfindungsgemäßen Oberflächenfunktionssystems mit einem Funktionsobjekt,
- Figur 7: eine schematische Darstellung einer exemplarischen Ausführungsform eines erfindungsgemäßen Gebäudeoberflächenfunktionssystems;
- Figur 8: eine schematische Darstellung einer zweiten exemplarischen Ausführungsform eines erfindungsgemäßen Gebäudeoberflächenfunktionssystems;
- Figur 9: eine schematische Darstellung einer dritten exemplarischen Ausführungsform eines erfindungsgemäßen Gebäudeoberflächenfunktionssystems;
- Figur 10: eine schematische Darstellung einer anderen exemplarischen Ausführungsform eines erfindungsgemäßen Gebäudeoberflächenfunktionssystems; und
- Figur 11: eine schematische Darstellung einer weiteren exemplarischen Ausführungsform eines erfindungsgemäßen Oberflächenfunktionssystems.

Es sei klar, dass die im Folgenden anhand der Figuren exemplarisch dargestellten erfindungsgemäßen Systeme und Vorrichtungen, die insbesondere zur Durchführung eines erfindungsgemäßen Verfahrens ausgelegt und eingerichtet sein können, in der vorliegenden Offenbarung nur schematisch dargestellt und exemplarisch beschrieben werden. Im Rahmen der Offenbarung sind zahlreiche Variationen gegenüber der exemplarisch dargestellten bevorzugten Ausführungsform denkbar.

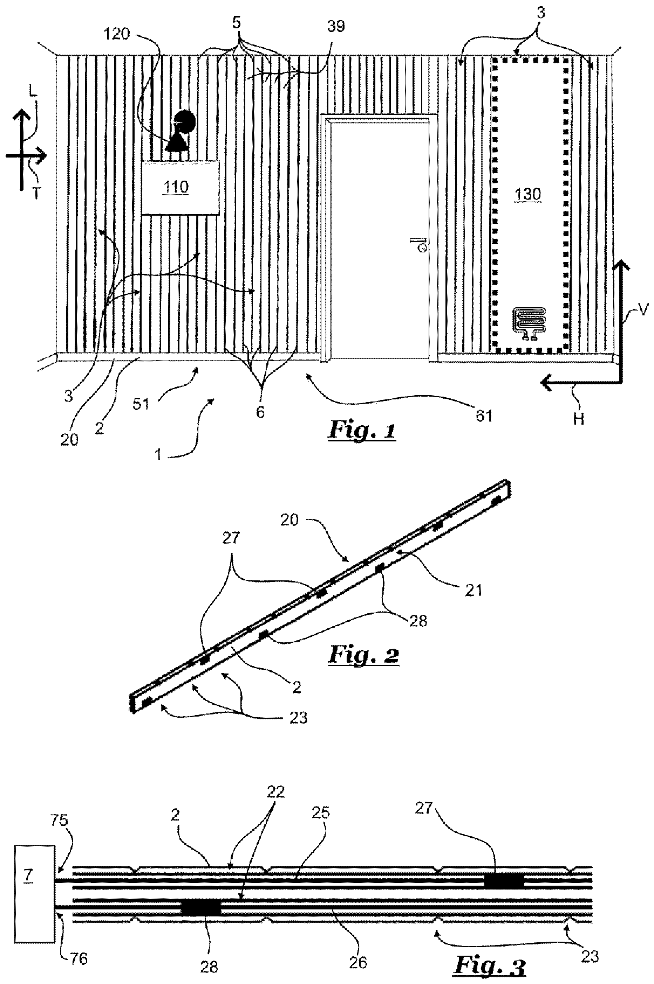

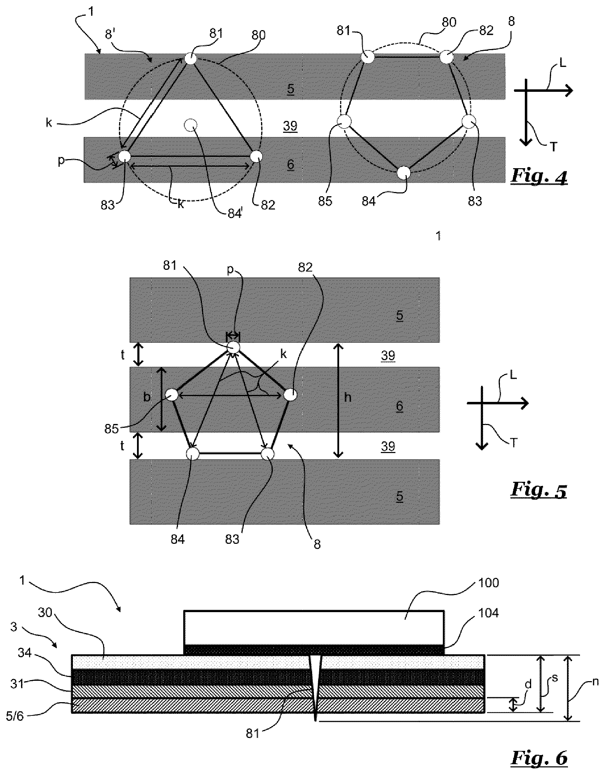

Fig. 1 zeigt schematisch ein als Gebäudeoberflächenfunktionssystem gestaltetes erfindungsgemäßes Oberflächenfunktionssystem 1. Das Oberflächenfunktionssystem 1 in der abgebildeten Ausführungsform umfasst ein Trägersystem 3, eine Vielzahl longitudinaler Flächenleiterbahnen 5, 6 und eine Kontaktleiste 2. Mögliche Ausführungsformen der Kontaktleiste 2 werden unten mit Verweis auf die Figuren 2 und 3 näher beschrieben. Die Ausgestaltung der Flächenleiterbahnen 5, 6 wird unter Bezugnahme auf die Figuren 4 bis 6 näher dargelegt. Anhand von Fig. 6 wird ferner exemplarisch ein Trägersystem 3 beschrieben.

Das Trägersystem kann beispielsweise eine Gipskartonplatte, eine Putzbeschichtung, eine Spachtelschicht, eine Farbschicht, eine Grundierungsschicht, eine Kunststofffolie und/oder eine Vlieslage insbesondere basierend auf Kunststoff-, Cellulose- oder Glasfaservliesen darstellen.

Das Oberflächenfunktionssystem 1 stellt an der dargestellten Rauminnenwand eine Flächenstromversorgung im Niedervoltbereich mit beispielsweise 12 V bereit. Durch das Oberflächenfunktionssystem werden verschiedene Funktionsobjekte 100 an der Wand gehalten und/oder mit elektrischer Energie im Niedervoltbereich versorgt. Ein exemplarisches Funktionsobjekt 100 ist die Lampe 120. Ein anderes exemplarisches Funktionsobjekt 100 ist das flächige Heizelement 130. Das Oberflächenfunktionssystem 1 versorgt die Lampe 120 und das Heizelement 130 mit Strom im Niedervoltbereich. Die aktiven Funktionsobjekte 120, 130 umfassen elektrische Verbraucher und sind zur Versorgung dieser elektrischen Verbraucher mit einem oder mehreren Stromaufnehmern ausgestattet (in Fig. 1 nicht näher dargestellt). Die Stromaufnehmer sind dazu ausgelegt und eingerichtet, eine elektrische Verbindung mit den Flächenleiterbahnen 5, 6 einzugehen, um die aktiven Funktionsobjekte 120, 130 mit elektrischer Energie zu versorgen.

Zur Flächenstromversorgung ist das Oberflächenfunktionssystem 1 mit der Vielzahl an elektrischen Leiterbahnen 5, 6 ausgestattet, die sich in longitudinaler Richtung L erstrecken. Die Transversalbreite b der Leiterbahnen 5, 6 in transversaler Richtung T quer, insbesondere orthogonal zu der longitudinale Richtung L ist um Größenordnungen kleiner als deren longitudinale Erstreckung. Die Leiterbahnen 5, 6 sind streifenförmig. Die Dicke der Flächenleiterbahnen 5, 6 ist sehr viel kleiner als deren longitudinale Erstreckung und wesentlich kleiner, insbesondere um Größenordnungen kleiner, als die Transversalbreite b.

Im Bereich des Trägersystems 3 sind die Leiterbahnen 5, 6 nicht elektrisch miteinander verbunden, sondern gegeneinander elektrisch isoliert, insbesondere durch leiterfreie Bereiche 39. Die Leiterbahnen 5 und 6 können in einem ersten Satz Leiterbahnen 5 und einen zweiten Satz Leiterbahnen 6 unterteilt sein, insbesondere anhand ihrer elektrischen Eigenschaften und/oder räumlichen Anordnung. An oder in dem Trägersystem 3 sind wechselweise die Leiterbahnen des ersten Satzes Leiterbahnen 5 und die des zweiten Satzes Leiterbahnen 6 angeordnet. Alle Leiterbahnen 5 und 6 haben nebeneinander angeordnete Anschlussenden 51 beziehungsweise 61. Bei der in Fig. 1 dargestellten Ausführungsform befinden sich alle Anschlussenden 51, 61 an dem in Vertikalrichtung V (hier entsprechend der longitudinalen Richtung L) unteren longitudinale Ende des Trägersystems 3. Die Anschlussenden 51, 61 sind im Bereich der Kontaktleiste 2 angeordnet, die hier als Abdeckleiste 20, nämlich als Fußleiste gebildet ist. In alternativen, nicht abgebildeten Ausführungsform könnte die Kontaktleiste als Deckenleiste gebildet sein oder als eine Leiste, die sich in der transversalen Richtung quer entlang dem Trägersystem erstreckt. Der Abstand des ersten Leiterbandes 25 vom zweiten Leiterband 26 in der longitudinalen Richtung L ist gering, damit die Anschlussenden 51 und 61 nebeneinander angeordnet sind.

Exemplarische Kontaktleisten 2 sind in den Figuren 2 und 3 dargestellt. Im Inneren der Abdeckleiste 20 verborgen sind Leiterbänder 25, 26 zur Stromversorgung der Leiterbahnen 5, 6 vorgesehen. Ein erstes Leiterband 25 ist mit den Anschlussenden 51 des ersten Satzes an elektrischen Leiterbahnen 5 elektrisch verbunden. Ein zweites Leiterband 26 ist mit den Anschlussenden 61 des zweiten Satzes an elektrischen Leiterbahnen 6 elektrisch verbunden. Das erste Leiterband 25 kann mit einem ersten Pol 75 einer Gleichstromquelle 7 und das zweite Leiterband 26 mit dem zweiten Pol 76 dieser Gleichstromquelle 7 verbunden sein, wobei zwischen den Gleichstromquellen eine Potenzialdifferenz im Niedervoltbereich vorherrscht.

Die Funktionsobjekte 100 sind in der hier dargestellten bevorzugten Ausführungsform mit einer magnetisch aktiven Rückseite 104 ausgestattet. Das Trägersystem 3 umfasst eine magnetisierbare oder magnetische Haltelage 34. Die Haltelage 34 kooperiert mit der magnetisch aktiven Rückseite 104 der Funktionsobjekte 100, um diese reversibel ortsfest an der Wand zu halten. Das Bild im Bilderrahmen 110 kann ein passives Funktionsobjekt ohne elektrischen Verbraucher und dementsprechend ohne Stromaufnehmer sein.

Die perspektivische Ansicht der als Abdeckleiste 20 gebildeten Kontaktleiste 2 in Fig. 2 zeigt deren wandseitige Rückseite 21, an der die Kontaktstellen 27 und 28 vorgesehen sind. Damit das erste Leiterband 25 die Leiterbahnen des ersten Satzes an Leiterbahnen 5 elektrisch kontaktiert und das zweite Leiterband 26 die Leiterbahnen des zweiten Satzes an Leiterbahnen 6, sind die ersten Kontaktstellen 27 des ersten Leiterbandes 25 in der transversalen Richtung T relativ zu den zweiten Kontaktstellen 28 des zweiten Leiterbandes 26 versetzt. Der Versatz der ersten und zweiten Kontaktstellen 27, 28 zueinander in transversaler Richtung T kann dem Abstand benachbarter Leiterbahnen 5 und 6 entsprechen. Zusätzlich kann vorgesehen sein, dass die ersten Kontaktstellen 27 des ersten Leiterbandes 25 in der longitudinalen Richtung L, die hier der Vertikalrichtung V entspricht, relativ zu den zweiten Kontaktstellen 28 des zweiten Leiterbandes 26 versetzt sind.

Fig. 3 zeigt eine schematische Darstellung einer Vorderseite beziehungsweise eines Querschnitts einer elektrischen Kontaktleiste 2. Die elektrische Kontaktleiste 2 kann als Abdeckleiste 20 gebildet sein; in diesem Fall fehlt bei der in Fig. 3 abgebildeten Ausführung vom jedoch eine Sichtblende. Der Blick in Fig. 3 ist frei auf das erste Leiterband 25 und das zweite Leiterband 26, die parallel zueinander in rinnenförmigen Aufnahmen 22 der elektrischen Kontaktleiste 2 angeordnet sind. Die Gleichspannungsquelle 7, beispielsweise ein Netzteil, hat einen ersten Pol 75 und einen zweiten Pol 76. Das erste Leiterband 25 ist an dem ersten Pol 75 angeschlossen und das zweite Leiterband 26 dem zweiten Pol 76.

Die Kontaktleiste 2 kann profilartig gebildet sein, beispielsweise extrudiert sein. Zum Einkürzen beziehungsweise Ablängen der Kontaktleiste ist die Kontaktleiste 2 in regelmäßigen Abständen mit Kerben 23 oder anderen Sollbruchstellen versehen.

Die Figuren 4 und 5 zeigen unterschiedliche Stromaufnehmer 8, 8', die mit den Flächenleiterbahnen 5 und 6 des ersten und des zweiten Satzes kooperieren. Der in Fig. 4 links dargestellte Stromaufnehmer 8 'umfasst 4 elektrische Kontaktelemente 81, 82, 83 und 84'. Drei der Kontaktelemente 81, 82 und 83 sind paarweise im gleichen Kontaktabstand k relativ zueinander angeordnet und spannen ein gleichschenkliges Dreieck auf. Diese Kontaktelemente 81, 82, 83 liegen auf einem Kreisumfang 80. Das vierte elektrische Kontaktelemente 84' ist inmitten des Dreiecks, insbesondere an dessen Mittelpunkt angeordnet. Die Kontaktelemente 81, 82, 83 und 84'haben die gleiche nadelförmig Gestalt und Querschnittsbreite p.

Ein erstes Kontaktelement 81 bildet eine elektrische Verbindung mit einer ersten Flächenleiterbahn 5. Ein zweites und ein drittes Kontaktelemente 82, 83 bilden einen elektrischen Kontakt mit der zweiten Flächenleiterbahn 6. Das vierte Kontaktelement 84' befindet sich im leiterfreien Bereich 39 zwischen den benachbarten Leiterbahnen 5 und 6. Der Stromaufnehmer 8 'umfasst einen nicht näher dargestellten Kontaktierungsadapter mit nicht näher dargestellter Gleichrichterschaltung, welche dazu eingerichtet ist, dass ein elektrischer Verbraucher durch den Stromaufnehmer 8 'stets mit elektrischer Energie versorgbar ist, unabhängig davon, welches oder welche der verschiedenen Kontaktelemente 81, 82, 83, 84' mit der ersten oder zweiten Flächenleiterbahn 5 oder 6 in Kontakt stehen, solange nur zumindest ein beliebiges Paar Kontaktelemente einerseits mit einer Leiterbahn 5 des ersten Satzes an Leiterbahnen und andererseits mit einer Leiterbahn 6 des zweiten Satzes an Leiterbahnen in Kontakt steht, sodass an dem Kontaktelement-Paar (hier: 81-83 oder 81-82) eine Potenzialdifferenz anliegt.

Der andere in Figur 4 dargestellte Stromaufnehmer 8 umfasst fünf auf einem Kreisumfang 80 in gleichen Abständen angeordnete Kontaktelemente 81, 82, 83, 84 und 85. Die Kontaktelemente 81, 82, 83, 84 und 85 bilden die Eckpunkte eines gleichschenkligen Fünfecks. Mit Ausnahme der Form gilt für diesen Stromaufnehmer 8 im Wesentlichen dasselbe wie für den oben beschriebenen Stromaufnehmer 8. Auch bei dem Stromaufnehmer 8 stehen Kontaktelemente-Paare (hier: 81-84 oder 82-84) einerseits mit einer Leiterban 5 des ersten Satzes und andererseits mit einer Leiterbahn 6 des zweiten Satzes in elektrisch leitender Verbindung. In dem abgebildeten Beispiel liegen zwei Kontaktelemente 83, 85 in dem leiterfreien Bereich 39.

Die verschiedenen Flächenleiterbahnen 5, 6 haben in den abgebildeten Ausführungsformen eine gleichförmige Transversalbreite b. Die leiterfreien Bereiche definieren zwischen den benachbarten Flächenleiterbahnen 5, 6 einen Transversalabstand t. Die benachbarten Flächenleiterbahnen 5 und 6 sind parallel zueinander orientiert.

Bei dem in Figur 5 dargestellten erfindungsgemäße Oberflächenfunktionssystem 1 ist eine besonders bevorzugte Relation der Maße der Flächenleiterbahnen 5, 6 in Relation zu dem Stromaufnehmer 8 realisiert. Der Stromaufnehmer 8 hat wiederum eine gleichschenklige Pentagon-Konfiguration der Kontaktelemente 81, 82, 83, 84, 85. Zwischen benachbarten Flächenleiterbahnen 5 und 6 ist je ein leiterbahnfreier Bereich 39 vorgesehen. Alle Flächenleiterbahnen 5, 6 haben im Wesentlichen die gleiche Transversalbreite b und den gleichen Transversalabstand t zur jeweils benachbarten Flächenleiterbahn 6 oder 5. Der Transversalabstand t zwischen zwei benachbarten Flächenleiterbahnen 5 und 6 ist kleiner als die Transversalbreite b, vorzugsweise kleiner als die Hälfte der Transversalbreite 5, besonders bevorzugt kleiner als ein Viertel der Transversalbreite und/oder größer als ein Zwanzigstel, insbesondere größer als ein Zehntel. Die Querschnittsbreite p der Kontaktelemente ist gleich groß und, insbesondere 1 mm, kleiner als der Transversabstand t.

Gegenüberliegende Kontaktelemente 81, 82, 83, 84, 85 können Paarweise betrachtet werden, wobei die Paare jeweils um einen Kontaktabstand k zueinander beabstandet sind. Bei dem abgebildeten gleichschenkligen Fünfeck sind die Kontaktabstände k aller Paare gleich groß. Andere Konfigurationen sind denkbar. Der Kontaktabstand k des Stromaufnehmers 8 ist größer als die Summe einer Transversalbreite b und eines Transversalabstands t, insbesondere größer als ein Transversalmodul h, wobei das Transversalmodul h der Summe zweier Transversalabstände t und einer Transversalbreite b entspricht. Der Kontakabstand k des Stromaufnehmers 8 ist kleiner als die Summe zweier Transversalbreiten b und eines Transversalabstands t.

Die obigen Darlegungen anhand eines Stromaufnehmers 8 mit pentagonal angeordneten Kontaktelementen 81, 82, 83, 84, 85 gelten entsprechend für andere Vieleckkonfigurationen.

Überraschenderweise hat sich gezeigt, dass sich eine Kontaktierungswahrscheinlichkeit von wenigstens 95%, insbesondere wenigstens 99%, bereits mit Kontaktelementen mit einem verhältnismäßig kleinen Kontaktelemente-Kreisumfang 80 realisieren lässt. Durch die hohe Kontaktierungswahrscheinlichkeit wird eine einfache und sichere Verwendung gewährleistet. Für Flächenleiterbahnen 5, 6 mit einer Transversalbreite b von etwa 25 mm und einem Transversalabstand t von etwa 3 mm konnten überraschenderweise die nachfolgenden Werte für einen optimalen kleinen Umkreisdurchmesser mit höchster Kontaktierungswahrscheinlichkeit festgestellt werden:

| **Stromaufnehmer** | **Umkreisdurchmesser** |
|---|---|
| gleichseitiges Dreieck mit Mittelkontakt | 4,1 cm |
| gleichseitiges Pentagon | 3,4 cm |
| gleichseitiges Heptagon | 3,2 cm |

Ferner hat sich gezeigt, dass das Verhältnis von Transversalbreite b zur Summe von Transversalbreite b und Transversalabstand t modifizierbar ist, wobei eine hohe Kontaktierungswahrscheinlichkeit selbst bei verringerter Flächenbedeckung mit Flächenleiterbahnen 5, 6 aufrecht erhalten werden kann, gegebenenfalls bei vergrößertem Umkreisdurchmesser 80 von vorzugsweise nicht mehr als 6 cm, insbesondere nicht mehr als 5,5 cm. Beispielsweise kann die Flächenabdeckung reduziert werden durch eine Vergrößerung des Transversalabstands auf wenigstens 5 mm, insbesondere wenigstens 6 mm, vorzugsweise wenigstens 7,5 mm, besonders bevorzugt wenigstens 16,5 mm. Alternativ oder zusätzlich kann die Flächenbedeckung reduziert werden durch eine Verkleinerung der Transversalbreite. Abweichend von der bevorzugten Flächenbedeckung von etwa 89 % kann eine reduzierte Flächenbedeckung von nicht mehr als 80 %, vorzugsweise nicht mehr als 76 %, insbesondere nicht mehr als 60% vorgesehen sein. Vorzugsweise ist für einen Stromaufnehmer 8 'mit Kontaktelementen in Form eines gleichseitigen Dreiecks mit Mittelkontakt die Flächenbedeckung wenigstens 75%. Vorzugsweise ist für einen Stromaufnehmer 8 mit Kontaktelementen in Form eines gleichseitigen Pentagons die Flächenbedeckung wenigstens 70%. Vorzugsweise ist für einen Stromaufnehmer mit Kontaktelementen in Form eines gleichseitigen Heptagons die Flächenbedeckung wenigstens 55%.

Fig. 6 zeigt eine exemplarische Querschnittsansicht eines Oberflächenfunktionssystems 1. Bei diesem Oberflächenfunktionssystem 1 sind die Flächenleiterbahnen 5 und 6 an der rückseitigen Oberfläche der Trägerlage 31 des Trägersystems 3 vorgesehen. Das Trägersystem 3 kann beispielsweise als Bahnmaterial, beispielsweise als Vlieslage, insbesondere basierend auf Kunststoff-, Cellulose- oder Glasfaservliesen gebildet sein. Die Trägerlage 31 kann alternativ oder zusätzlich als eine Kunststofffolie realisiert sein.

Andere Ausgestaltungen der Trägerlage 31 und/oder des Trägersystems 3 sind denkbar, beispielsweise können die Flächenleiterbahnen 5 und 6 an verschiedenen Seiten der Trägerlage oder an der Vorderseite der Trägerlage 31 angeordnet sein. Alternativ ist es denkbar, dass das Trägersystem 3 beispielsweise als Putzbeschichtung, Spachtelschicht oder dergleichen realisiert ist und die Flächenleiterbahnen 5 und 6 in das Trägersystem 3 eingebettet vorliegen (nicht abgebildet). Die Trägerlage 31 kann in Funktionsunion eine magnetische oder magnetisierbar Haltelage realisieren.

Bei der bevorzugten Ausführungsform gemäß Fig. 6 ist eine magnetisierbare Haltelage 34 auf der Trägerlage 31 vorgesehen. An der Vorderseite des Trägersystem 3 ist eine Dekorbeschichtung 30 vorgesehen. Das Trägersystem 3 kooperiert mit einem Funktionsobjekt 100. Das Funktionsobjekt hat mehrere nadelförmige Kontaktelemente 81 (nur eines abgebildet), die dazu ausgelegt und eingerichtet sind, in das Trägersystem 3 einzudringen und in einen Berührkontakt mit der Flächenleiterbahn 5/6 gebracht oder bringbar zu sein. Vorzugsweise sind die nadelförmigen Kontaktelemente 81 dazu ausgebildet zumindest die Flächenleiterbahn 5 oder 6, insbesondere das Trägersystem 3, zu durchdringen. Die Flächenleiterbahnen 5 und 6 haben eine Bahndicke d. Die Bahndicke d ist bevoruugt weniger als 1 mm, insbesondere weniger als 0,1 mm. Die Nadellänge oder allgemein Kontaktelementlänge n des Kontaktelements 81 ist in der dargestellten Ausführungsform größer als die Bahndicke d. Das Trägersystem 3 weist eine Systemdicke s auf. Vorzugsweise ist die Nadellänge n wenigstens so groß wie die Systemdicke s.

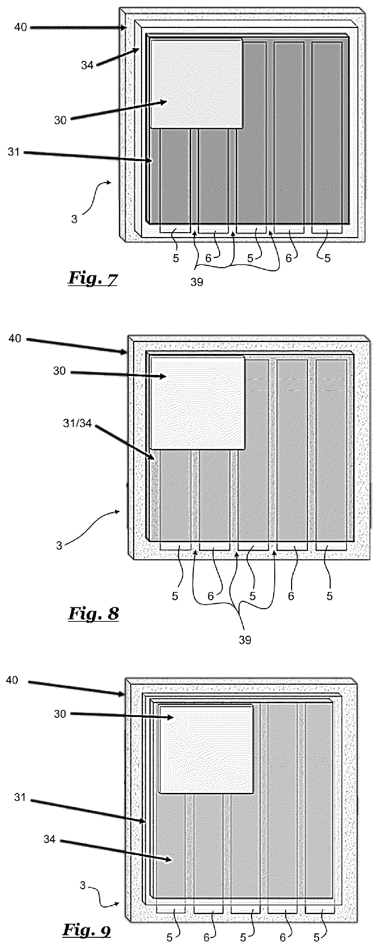

Figur 7 zeigt eine schematische Darstellung einer exemplarischen Ausführungsform eines erfindungsgemäßen Gebäudeoberflächenfunktionssystems1. Die Flächenleiterbahnen 5, 6 sind auf eine Trägerlage 31 in Form eines Cellulose- oder Glasfaservlies rückseitig aufgebracht. An der Sichtseite der Trägerlage 31 ist eine als Dekorbeschichtung dienende Decklage 30 aufgebracht. Die Trägerlage 31 ist an dem Untergrund 40, der durch eine Betonmauer gebildet sein kann, mit einer Spachtelmasse angebracht. Die Spachtelmasse ist magnetisierbar und dient somit als Halteschicht 34.

Figur 8 zeigt eine schematische Darstellung einer zweiten exemplarischen Ausführungsform eines erfindungsgemäßen Gebäudeoberflächenfunktionssystems. Das Trägersystem 3 umfasst ein in Funktionsunion als Trägerlage 31 und Haltelage 34 dienendes magnetisch rezeptives Vlies. Das Vlies der Haltelage 34 umfasst große Anteile eines ferro- oder ferrimagnetisch rezeptiven Materials. Die Leiterbahnen 5 und 6 sind an dem Vlies befestigt, dass die Träger- und Haltelage 31, 34 bildet. Die Leiterbahnen 5, 6 können direkt auf dem Magnetvlies rückseitig angebracht sein. Das Magnetvlies kann selbstklebend sein. An der sichtbaren Vorderseite des Trägersystems 3 ist eine Dekorlage 30 durch eine optisch ästhetisch hochwertige, gut weiter verarbeitbare Deckbeschichtung gebildet.

Figur 9 zeigt eine schematische Darstellung einer dritten exemplarischen Ausführungsform eines erfindungsgemäßen Gebäudeoberflächenfunktionssystems. Von der oben bezüglich Figur 7 beschriebenen Ausführungsform unterscheidet sich die des in Fig. 9 abgebildeten Gebäudeoberflächenfunktionssystems im Wesentlichen dadurch, dass die Haltelage 34 nicht hinter der Trägerlage 31 vorgesehen ist, sondern dass die Haltelage 34 rauminnenseitig an der Vorderseite der Trägerlage 31 angeordnet ist. Die Haltelage 34 kann in dem dargestellten Ausführungsbeispiel als ein magnetisch rezeptiver Anstrich realisiert sein. Dieser Anstrich kann eine Farbe sein, die große Mengen eines magnetisch rezeptiven Materials enthält. Gemäß einer nicht näher dargestellten Alternative könnte das Vlies rauminnenseitig auf einen derartigen Haltelagen-34-Anstrich aufgeklebt sein. An der Sichtseite des Trägersystems 3 kann zudem, wie abgebildet, eine Deckbeschichtung als Dekorlage 30 vorgesehen sein.

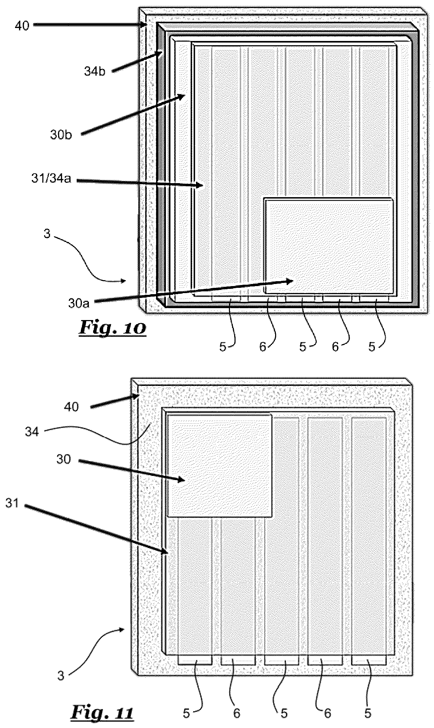

Figur 10 zeigt eine schematische Darstellung einer anderen exemplarischen Ausführungsform eines erfindungsgemäßen Gebäudeoberflächenfunktionssystems. Dabei können die Flächenleiter 5, 6 auf eine magnetisch aktive Folie oder ein magnetisch aktives Vlies aufgebracht sein, welche(s) in Funktionsunion als Trägerlage 31 und erste Haltelage 34a dient. Rauminnenseitig kann eine Decklage als Dekorlage 30a vorgesehen sein. Auf dem Untergrund 40, beispielsweise einer Betonwand oder anderen Gebäudewand, ist eine weitere zweite Haltelage 34b aufgebracht, beispielsweise als Spachtelmasse, Vlies oder Farbanstrich. Die Haltelage ist von einer zweiten Decklage 30b überdeckt, die dafür sorgt, dass die zweite Haltelage 34b nicht erkennbar ist. Eine solche Ausgestaltung mit mehreren magnetisierbaren Haltelagen 34a, 34b kann eine besonders hohe magnetische Haftkraft bereitstellen.

Figur 11 zeigt eine schematische Darstellung einer weiteren exemplarischen Ausführungsform eines erfindungsgemäßen Oberflächenfunktionssystems. Bei dieser Ausführungsform ist rauminnenseitig eine Decklage als Dekorlage 30 vorgesehen, hinter der eine kombinierte Trägerlage 31 aus einem Trägervlies bereitgestellt ist. Rückseitig davon ist eine magnetisch rezeptive Gipskartonplatte als Haltelage 34 vorgesehen. Die Halteplatte 34 ist gebildet als eine Gipskartonplatte, die neben Gips große Anteile eines ferro- oder ferrimagnetisch rezeptiven Materials enthält. Alternativ können die Flächenleiterbahnen 5, 6 auf die Gipskartonplatte aufgebracht oder darin eingebettet sein (nicht abgebildet), wobei das Vlies zwischen der Gipskartonplatte und der Dekorschicht 30 weiterhin vorgesehen oder ausgespart sein kann.

Die in der voranstehenden Beschreibung, den Ansprüchen und den Zeichnungen offenbarten Merkmale der Erfindung können sowohl einzeln als auch in jeder beliebigen Kombination für die Verwirklichung der Erfindung in ihren verschiedenen Ausführungsformen wesentlich sein.

### Bezugszeichenliste

- 1: Oberflächenfunktionssystem
- 2: elektrische Kontaktleiste
- 3: Trägersystem
- 5: Flächenleiterbahn
- 6: Flächenleiterbahn
- 7: Gleichspannungsquelle
- 8, 8': Stromaufnehmer
- 20: Abdeckleiste
- 21: Rückseite
- 22: Aufnahmen
- 25: erstes Leiterband
- 26: zweites Leiterband
- 27: Kontaktstelle
- 28: Kontaktstelle
- 30, 31a, 31b: Decklage
- 31: Trägerlage
- 34, 34a, 34b: Haltelage
- 40: Untergrund
- 51: Anschlussende
- 61: Anschlussende
- 71: erster Pol
- 72: zweiter Pol
- 80: Kreis
- 81: Kontaktelement
- 82: Kontaktelement
- 83: Kontaktelement
- 84: Kontaktelement
- 84': Kontaktelement
- 85: Kontaktelement
- 100: Funktionsobjekt
- 104: magnetisch aktive Rückseite
- 110: Bilderrahmen
- 120: Lampe
- 130: Heizelement
- b: Transversalbreite
- d: Bahndicke
- h: Transversalmodul
- k: Paarabstand
- n: Kontaktelementlänge
- p: Querbreite
- s: Systemdicke
- t: Transversalabstand

- H: Horizontalrichtung
- L: Longitudinalrichtung
- T: Transversalrichtung
- V: Vertikalrichtung

## Patentansprüche

1. Oberflächenfunktionssystem (1) für die Flächenstromversorgung im Niedervoltbereich, insbesondere Gebäudeoberflächenfunktionssystem, umfassend
a) ein Trägersystem (3), insbesondere eine Trägerlage (31),
b) eine Vielzahl an longitudinalen elektrischen Flächenleiterbahnen (5, 6), wobei die die Vielzahl an elektrischen Flächenleiterbahnen (5, 6) vorder- oder rückseitig an dem Trägersystem (3) oder eingebettet in das Trägersystem (3) vorliegen, wobei die Vielzahl an longitudinalen elektrischen Flächenleiterbahnen (5,6) jeweils ein Anschlussende (51, 61) aufweisen, wobei die Anschlussenden nebeneinander angeordnet sind, und dass das Oberflächenfunktionssystem (1) ferner umfasst
c) eine, insbesondere flexible, elektrische Kontaktleiste (2), enthaltend mindestens ein erstes und mindestens ein zweites elektrisch leitfähiges Leiterband (25, 26), die benachbart zueinander verlaufen, und
f) mindestens eine magnetisierbare oder magnetische Haltelage (34),
wobei das erste Leiterband (25) mit einem ersten Pol (75) einer Gleichspannungsquelle (7) und das zweite Leiterband (26) mit einem zweiten Pol (76) der Gleichspannungsquelle (7) verbindbar ist,
wobei das erste Leiterband (25) Kontaktstellen (27) für die elektrisch leitende Verbindung der Anschlussenden (51) eines ersten Satzes an elektrischen Flächenleiterbahnen (5) mit dem ersten elektrisch leitfähigen Leiterband (25) aufweist und
wobei das zweite Leiterband (26) Kontaktstellen (28) für die elektrisch leitende Verbindung der Anschlussenden (61) eines zweiten Satzes an elektrischen Flächenleiterbahnen (6) mit dem zweiten elektrisch leitfähigen Leiterband (26) aufweist,
wobei die elektrischen Flächenleiterbahnen (5, 6) des ersten und zweiten Satzes an elektrischen Flächenleiterbahnen jeweils alternierend zueinander angeordnet sind,
wobei die Anschlussenden der elektrischen Flächenleiterbahnen des ersten Satzes an elektrischen Flächenleiterbahnen reversibel mit den Kontaktstellen des ersten elektrisch leitfähigen Leiterbandes verbindbar oder verbunden sind und
wobei die Anschlussenden der elektrischen Flächenleiterbahnen des zweiten Satzes an elektrischen Flächenleiterbahnen reversibel mit den Kontaktstellen des zweiten elektrisch leitfähigen Leiterbandes verbindbar oder verbunden sind,
**dadurch gekennzeichnet, dass**
die magnetisierbare oder magnetische Haltelage (34) vorderseitig an dem Trägersystem (3), insbesondere der Trägerlage, vorliegt, und
**dass** die magnetisierbare oder magnetische Haltelage (34) eine Putzbeschichtung, eine Spachtelschicht, eine Farbschicht, eine Grundierungsschicht und/oder eine Vlieslage umfasst oder darstellt, die jeweils mit magnetisierbaren Materialien ausgestattet ist.

2. Oberflächenfunktionssystem nach Anspruch 1, ferner umfassend
d) mindestens ein Niedervolt-Netzteil, verbunden oder verbindbar mit der elektrischen Kontaktleiste,
wobei das Netzteil vorzugsweise Bestandteil der Kontaktleiste, der Abdeckleiste oder der Putzbeschichtung ist.

3. Oberflächenfunktionssystem nach Anspruch 1 oder 2, ferner umfassend
e) eine insbesondere magnetisch oder magnetisierbar ausgestaltete, Abdeckleiste (20), insbesondere eine Fuß- und/oder Deckenleiste,
insbesondere **dadurch gekennzeichnet, dass**
die Kontaktleiste (2), insbesondere integraler, Bestandteil der Abdeckleiste (20), insbesondere Fuß- und/oder Deckenleiste, ist.

4. Oberflächenfunktionssystem nach einem der vorausgehenden Ansprüche, **dadurch gekennzeichnet, dass**
das Trägersystem, insbesondere die Trägerlage, magnetisierbar ausgestaltet ist.

5. Oberflächenfunktionssystem nach einem der vorausgehenden Ansprüche, **dadurch gekennzeichnet, dass**
die magnetisierbaren Materialien ferri- und/oder ferromagnetische Materialien, z.B. Magnetit, darstellen.

6. Oberflächenfunktionssystem nach einem der vorausgehenden Ansprüche, **dadurch gekennzeichnet, dass**
die Kontaktleiste einkürzbar ist, insbesondere vermittels vorgegebener Schwächungsareale, z.B. Einkerbungen.

7. Oberflächenfunktionssystem nach einem der vorausgehenden Ansprüche, **dadurch gekennzeichnet, dass**
die Vielzahl an Flächenleiterbahnen über eine im Wesentlichen einheitliche Transversalbreite verfügen oder dass
die Vielzahl an Flächenleiterbahnen über eine im Wesentlichen einheitliche longitudinale Ausdehnung verfügen oder dass
die Vielzahl an benachbarten Flächenleiterbahnen im Wesentlichen parallel verlaufen oder dass
die Vielzahl an benachbarten Flächenleiterbahnen jeweils durch eine leiterfreie Fläche (39) voneinander getrennt, insbesondere elektrisch isoliert, ist.

8. Oberflächenfunktionssystem nach Anspruch 7, **dadurch gekennzeichnet, dass** die leiterfreie Fläche (39) jeweils einen Transversalabstand (t) zwischen zwei benachbarten Flächenleiterbahnen definiert und die Flächenleiterbahnen jeweils eine Transversalbreite (b) zwischen zwei benachbarten leiterfreien Flächen (39) aufweisen, wobei die Transversalbreite (b) wenigstens so groß ist wie, insbesondere größer ist als, der Transversalabstand (t) und/oder wobei ein Transversalmodul (h) definiert ist als die Summe aus der Transversalbreite (b) einer elektrischen Flächenleiterbahn und dem Zweifachen eines Transversalabstands (t) der leiterfreien Fläche (39).

9. Oberflächenfunktionssystem nach Anspruch 7 oder 8, **dadurch gekennzeichnet, dass**
der Transversalabstand (t) im Bereich von wenigstens 1 mm bis 10 mm, insbesondere 2 mm bis 5 mm, vorzugsweise bei etwa 3 mm, liegt, und/oder dass die Transversalbreite (b) im Bereich von wenigstens 1 mm bis 50 mm, insbesondere 15 mm bis 35 mm, vorzugsweise bei etwa 25 mm, liegt.

10. Oberflächenfunktionssystem nach einem der vorausgehenden Ansprüche, ferner umfassend
g) mindestens einen Stromaufnehmer (8, 8') für einen elektrischen Verbraucher, umfassend mindestens zwei oder drei, bevorzugt mindestens fünf und besonders bevorzugt genau fünf, elektrisch leitende Kontaktelemente (81, 82, 83, 84, 85), ausgelegt und eingerichtet um mit zwei benachbarten elektrischen Flächenleiterbahnen (5, 6) wechselzuwirken, wobei
der Stromaufnehmer (8, 8') für einen elektrischen Verbraucher bevorzugt einen Kontaktierungsadapter enthaltend eine Gleichrichterschaltung darstellt.

11. Oberflächenfunktionssystem nach Anspruch 10, **dadurch gekennzeichnet, dass** der Stromaufnehmer (8, 8') für einen elektrischen Verbraucher mindestens eine magnetische Haltekomponente umfasst, insbesondere mit einer magnetischen Rückseite ausgestattet ist, die der Haltelage (34) zugewandt oder zuwendbar ist.

12. Oberflächenfunktionssystem nach Anspruch 10 oder 11, **dadurch gekennzeichnet, dass**
der Stromaufnehmer (8, 8') wenigstens zwei Anschlussaufnahmen, wie Anschlussklemmen, aufweist, die dazu ausgelegt und eingerichtet sind, je wenigstens eine elektrische Leitung eines elektrischen Verbrauchers aufzunehmen.

13. Oberflächenfunktionssystem nach Anspruch 10 bis 12, **dadurch gekennzeichnet, dass**
mehrere, insbesondere alle, der Kontaktelemente (81, 82, 83, 84, 85 ) in einem Kreisring, insbesondere auf einem Kreisumfang (80), liegen und/oder dass mehrere, insbesondere alle, benachbarten Kontaktelemente im Wesentlichen gleich weit voneinander entfernt sind, wobei insbesondere mehrere, vorzugsweise alle, der Kontaktelemente (81, 82, 83, 84, 85) ein bevorzugt gleichseitiges Vieleck bilden, wobei vorzugsweise wenigstens ein oder genau ein Kontaktelement (84') in dem Vieleck, insbesondere im Mittelpunkt des Vielecks, angeordnet ist.

14. Oberflächenfunktionssystem nach einem der Ansprüche 10 bis 13, **dadurch gekennzeichnet, dass**
mindestens ein Paar an Kontaktelementen desselben Stromaufnehmers (8, 8') einen Kontaktabstand (k) zueinander hat, der größer ist als die Summe aus der Transversalbreite (b) einer elektrischen Flächenleiterbahn und der Transversalabstand (t) der leiterfreien Fläche (39) und der kleiner als die Summe aus der doppelten Transversalbreite (b) einer elektrischen Flächenleiterbahn und dem Transversalabstand (t) der leiterfreien Fläche (39), wobei vorzugsweise der Kontaktabstand im Wesentlichen dem Transversalmodul (h) entspricht.

15. Oberflächenfunktionssystem nach einem der Ansprüche 10 bis 14, **dadurch gekennzeichnet, dass**
die Kontaktelemente (81, 82, 83, 84, 85) nadelförmig ausgestaltet sind, insbesondere mit einem konisch geformten Einsteckende, und/oder stiftförmig, insbesondere mit einem Zylinderabschnitt, ausgestaltet sind, wobei die Kontaktelemente vorzugsweise eine Querschnittsbreite (p) aufweisen, die kleiner ist als der Transversalabstand (t), insbesondere im Wesentlichen der Hälfte des Transversalabstands (t) entspricht und/oder wenigstens 0,5 mm, vorzugsweise wenigsten 1 mm, kleiner als der Transversalabstand (t) ist.

16. Oberflächenfunktionssystem nach Anspruch 15, **dadurch gekennzeichnet, dass** die Kontaktelemente eine Kontaktelementlänge (n) aufweisen, die größer ist als eine Bahndicke (d) der Leiterbänder und/oder größer ist als eine Systemdicke (s) des Trägersystems, wobei insbesondere die Kontaktelementlänge (n) wenigstens so groß ist wie die Summe von Bahndicke (d) und Systemdicke (s).

17. Oberflächenfunktionssystem nach einem der vorausgehenden Ansprüche, ferner umfassend
h) mindestens eine Dekorbeschichtung (30) vorderseitig an dem Trägersystem (3), insbesondere der Trägerlage (31), oder an der magnetisierbaren oder magnetischen Haltelage (34) vorliegend.

18. Oberflächenfunktionssystem nach einem der vorausgehenden Ansprüche, **dadurch gekennzeichnet, dass**
die mindestens eine, insbesondere die Vielzahl, an, insbesondere longitudinalen, elektrischen Flächenleiterbahnen (5, 6) ausgewählt sind aus der Gruppe bestehend aus metallischen Flächenleitern, insbesondere aus Kupfer- oder Aluminiumfolie, Bahnen aus, insbesondere mittels Druckverfahren aufgebrachter, elektrisch leitfähiger Tinte, leitfähigen Polymercompounds und Carbonfaser-basierten Systemen.

19. Oberflächenfunktionssystem nach einem der Ansprüche 4 bis 18, ferner umfassend mindestens ein Funktionsobjekt (100), wie ein Bild, einen Bilderrahmen (110), eine Magnethalterung, eine Wanduhr, ein Whiteboard, eine Tafel, ein Regal, einen Wandklapptisch, insbesondere enthaltend eine USB-Ladestation, ein Dekorationselement, einen Bildschirm, eine Projektionsfläche, einen Spiegel, einen Kerzenhalter, einen Gardinenhalter, Holzpaneele, Bilderleisten, Fliesen, Schienen, eine Vase, eine Ordnungsleiste, einen Ordnungshelfer, einen Hängeschrank, einen Deko-Kamin, eine Sockelleiste, eine Lampe (120), einen Hausautomationsschalter, eine Dämmstoffplatte, eine Akustikplatte, einen Lautsprecher, ein Radio, ein ActiveNoise Cancelling-System, ein Heizelement (130), ein Rauchmelder, GPS-Tracker, Flüssigkeitsspender, wie ein Seifenspender, oder Desinfektionsmittelspender und/oder ein Sensor, wie ein Raumsensor, beispielsweise ein Temperatursensor, Geräuschsensor, Helligkeitssensor, Bewegungssensor, Hygrometer, Personensensor, Vibrationssensor, wobei das Funktionsobjekt (100) mit einer magnetisch aktiven Rückseite (104) ausgestattet ist.

20. Verwendung des Oberflächenfunktionssystems gemäß einem der vorangehenden Ansprüche für die flächige Stromversorgung für Niedervolt-Applikationen von mindestens einem Stromaufnehmer für einen elektrischen Verbraucher, umfassend mindestens zwei oder drei, bevorzugt mindestens fünf und besonders bevorzugt genau fünf, elektrisch leitende Kontaktelemente, ausgelegt und eingerichtet, um mit zwei benachbarten elektrischen Flächenleiterbahnen wechselzuwirken.

21. Gebäudewand oder -decke oder Akustikkörper, insbesondere Akustikwand, enthaltend
mindestens ein Gebäudeoberflächenfunktionssystem gemäß einem der Ansprüche 1 bis 19.

22. Fertighaus mit einem Oberflächenfunktionssystem gemäß einem der Ansprüche 1 bis 19 und/oder einer Gebäudewand oder -decke nach Anspruch 21.

## Claims

1. Surface functional system (1) for surface power supply in the low voltage range, in particular building surface functional system, comprising
a) a support system (3), in particular a support layer (31),
b) a plurality of longitudinal electrical surface conductor paths (5, 6), wherein the plurality of electrical surface conductor paths (5, 6) are present on the front or rear side on the support system (3) or embedded in the support system (3),
wherein the plurality of longitudinal electrical surface conductor paths (5, 6) each having a connection end (51, 61), wherein the connection ends are arranged next to one another, and the surface functional system (1) further comprises
c) an, in particular flexible, electrical contact strip (2), containing at least one first and at least one second electrically conductive conductor band (25, 26), which run adjacent to one another,
wherein the first conductor band (25) can be connected to a first pole (75) of a DC voltage source (7) and the second conductor band (26) can be connected to a second pole (76) of the DC voltage source (7), and
f) at least one magnetizable or magnetic holding layer (34),
wherein the first conductor band (25) has contact points (27) for the electrically conductive connection of the connection ends (51) of a first set of electrical surface conductor paths (5) to the first electrically conductive conductor band (25), and
wherein the second conductor band (26) has contact points (28) for the electrically conductive connection of the connection ends (61) of a second set of electrical surface conductor paths (6) to the second electrically conductive conductor band (26),
wherein the electrical surface conductor paths (5, 6) of the first and second set of electrical surface conductor paths are each arranged alternately with respect to one another,
wherein the connection ends of the electrical surface conductor paths of the first set of electrical surface conductor paths are reversibly connectable or connected to the contact points of the first electrically conductive conductor band, and
wherein the connection ends of the electrical surface conductor paths of the second set of electrical surface conductor paths are reversibly connectable or connected to the contact points of the second electrically conductive conductor band,
**characterized in that**
the magnetizable or magnetic holding layer (34) is present on the front side on the support system (3), in particular the support layer, and
**in that** the magnetizable or magnetic holding layer (34) comprises or represents a plaster coating, a filler layer, a paint layer, a primer layer, and/or a non-woven layer, which is equipped in each case with magnetizable materials.

2. The surface functional system according to claim 1, further comprising
d) at least one low-voltage power supply connected or connectable to the electrical contact strip, wherein the power supply unit preferably is part of the contact strip, the cover strip or the plaster coating.

3. The surface functional system according to claim 1 or 2, further comprising
e) a cover strip (20), in particular configured to be magnetic or magnetizable, in particular a foot and/or ceiling strip, in particular **characterized in that**
the contact strip (2) is, in particular an integral, part of the cover strip (20), in particular foot and/or ceiling strip.

4. The surface functional system according to any one of the preceding claims, **characterized in that**
the support system, in particular the support layer, is configured to be magnetizable.

5. The surface functional system according to any one of the preceding claims, **characterized in that**
magnetizable materials represent ferrimagnetic and/or ferromagnetic materials, e.g. magnetite.

6. The surface functional system according to any one of the preceding claims, **characterized in that**
the contact strip can be shortened, in particular by way of predetermined weakening zones, e.g. notches.

7. The surface functional system according to any one of the preceding claims, **characterized in that**
the plurality of surface conductor paths have a substantially uniform transverse width, or
**in that** the plurality of surface conductor paths have a substantially uniform longitudinal extension, or
**in that** the plurality of adjacent surface conductor paths run substantially parallel, or **in that** the plurality of adjacent surface conductor paths are each separated from one another, in particular electrically insulated, by a conductor-free surface (39).

8. The surface functional system according to claim 7, **characterized in that**
the conductor-free surface (39) each defines a transverse distance (t) between two adjacent surface conductor paths and the surface conductor paths each have a transverse width (b) between two adjacent conductor-free surfaces (39), wherein the transverse width (b) is at least as large as, in particular greater than, the transverse distance (t) and/or wherein a transverse module (h) is defined as the sum of the transverse width (b) of an electrical surface conductor path and twice a transverse distance (t) of the conductor-free surface (39).

9. The surface functional system according to claim 7 or 8, **characterized in that**
the transverse distance (t) is in the range of at least 1 mm to 10 mm, in particular 2 mm to 5 mm, preferably about 3 mm, and/or **in that** the transverse width (b) is in the range of at least 1 mm to 50 mm, in particular 15 mm to 35 mm, preferably about 25 mm.

10. The surface functional system according to any one of the preceding claims, further comprising
g) at least one current collector (8, 8') for an electrical load, comprising at least two or three, preferably at least five and particularly preferably exactly five, electrically conductive contact elements (81, 82, 83, 84, 85), adapted and arranged to interact with two adjacent electrical surface conductor paths (5, 6), wherein the current collector (8, 8') for an electrical load preferably represents a contacting adapter containing a rectifier circuit.

11. The surface functional system according to claim 10, **characterized in that**
the current collector (8, 8') for an electrical load comprises at least one magnetic holding component, in particular is equipped with a magnetic rear side which faces or can face the holding layer (34).

12. The surface functional system according to claim 10 or 11, **characterized in that**
the current collector (8, 8') has at least two connection receptacles, such as connection terminals, which are adapted and arranged to each receive at least one electrical lead of an electrical load.

13. The surface functional system according to claim 10 to 12, **characterized in that**
a plurality, in particular all, of the contact elements (81, 82, 83, 84, 85) lie in a circular ring, in particular on a circular circumference (80), and/or **in that** a plurality, in particular all, of the adjacent contact elements are substantially equidistant from one another, wherein in particular a plurality, preferably all, of the contact elements (81, 82, 83, 84, 85) form a preferably equilateral polygon, wherein preferably at least one or exactly one contact element (84') is arranged in the polygon, in particular in the center of the polygon.

14. The surface functional system according to any one of claims 10 to 13, **characterized in that**
at least one pair of contact elements of the same current collector (8, 8') has a contact distance (k) from one another which is greater than the sum of the transverse width (b) of an electrical surface conductor path and the transverse distance (t) of the conductor-free surface (39) and which is smaller than the sum of twice the transverse width (b) of an electrical surface conductor path and the transverse distance (t) of the conductor-free surface (39), wherein preferably the contact distance substantially corresponds to the transverse module (h).

15. The surface functional system according to any one of claims 11 to 14, **characterized in that**
the contact elements (81, 82, 83, 84, 85) are configured to be needle-shaped, in particular with a conically shaped insertion end, and/or pin-shaped, in particular with a cylindrical section, wherein the contact elements preferably have a cross-sectional width (p) which is smaller than the transverse distance (t), in particular substantially corresponds to half the transverse distance (t), and/or is at least 0.5 mm, preferably at least 1 mm, smaller than the transverse distance (t).

16. The surface functional system according to claim 15, **characterized in that**
the contact elements have a contact element length (n) which is greater than a path thickness (d) of the conductor bands and/or greater than a system thickness (s) of the support system, wherein in particular the contact element length (n) is at least as large as the sum of path thickness (d) and system thickness (s).

17. The surface functional system according to any one of the preceding claims, further comprising
h) at least one decorative coating (30) present on the front side on the support system (3), in particular the support layer (31), or on the magnetizable or magnetic holding layer (34).

18. The surface functional system according to any one of the preceding claims, **characterized in that**
the at least one, in particular the plurality of, in particular longitudinal, electrical surface conductor paths (5, 6) are selected from the group consisting of metallic surface conductors, in particular of copper or aluminium foil, paths of electrically conductive ink applied in particular by way of printing methods, conductive polymer compounds and carbon fiber-based systems.

19. The surface functional system according to any one of claims 4 to 18, further comprising
at least one functional object (100), such as a picture, a picture frame (110), a magnetic holder, a wall clock, a whiteboard, a panel, a shelf, a wall folding table, in particular containing a USB charging station, a decoration element, a screen, a projection surface, a mirror, a candle holder, a curtain holder, wooden panels, image strips, tiles, rails, a vase, an order strip, an order shelf, a hanging cabinet, a decorative fireplace, a socket strip, a lamp (120), a home automation switch, an insulation panel, an acoustic panel, a loudspeaker, a radio, an active noise cancelling system, a heating element (130), a smoke alarm, GPS tracker, liquid dispenser, such as a soap dispenser, or disinfectant dispenser and/or a sensor, such as a room sensor, for example a temperature sensor, noise sensor, brightness sensor, movement sensor, hygrometer, person sensor, vibration sensor, wherein the functional object (100) is equipped with a magnetically active rear side (104).

20. Use of the surface functional system according to any one of the preceding claims for the areal power supply for low-voltage applications of at least one current collector for an electrical load, comprising at least two or three, preferably at least five and particularly preferably exactly five, electrically conductive contact elements, adapted and arranged to interact with two adjacent electrical surface conductor paths.

21. Building wall or ceiling or acoustic body, in particular acoustic wall, containing
at least one building surface functional system according to any one of claims 1 to 19.

22. Prefabricated house with a surface functional system according to any one of claims 1 to 19 and/or a building wall or ceiling according to claim 21.

## Revendications

1. Système fonctionnel de surface (1) pour l'alimentation en courant de surface dans le domaine des basses tensions, en particulier système fonctionnel de surface de bâtiment, comprenant
a) un système de support (3), en particulier une couche de support (31),
b) une pluralité de bandes conductrices de surface électriques longitudinales (5, 6), la pluralité de bandes conductrices de surface électriques (5, 6) se trouvant à l'avant ou à l'arrière sur le système de support (3) ou intégrées dans le système de support (3),
la pluralité de bandes conductrices de surface électriques longitudinales (5, 6) présentant à chaque fois une extrémité de raccordement (51, 61), les extrémités de raccordement étant disposées les unes à côté des autres, et en ce que le système fonctionnel de surface (1) comprend en outre
c) une bande de contact électrique (2), en particulier flexible, contenant au moins une première et au moins une deuxième bande conductrice électriquement conductrice (25, 26), qui s'étendent de manière adjacente l'une à l'autre, et
f) au moins une couche de maintien magnétisable ou magnétique (34),
la première bande conductrice (25) pouvant être connectée à un premier pôle (75) d'une source de tension continue (7) et la deuxième bande conductrice (26) pouvant être connectée à un deuxième pôle (76) de la source de tension continue (7),
la première bande conductrice (25) présentant des points de contact (27) pour la connexion électriquement conductrice des extrémités de raccordement (51) d'un premier ensemble de bandes conductrices de surface électriques (5) à la première bande conductrice électriquement conductrice (25) et
la deuxième bande conductrice (26) présentant des points de contact (28) pour la connexion électriquement conductrice des extrémités de raccordement (61) d'un deuxième ensemble de bandes conductrices de surface électriques (6) à la deuxième bande conductrice électriquement conductrice (26),
les bandes conductrices de surface électriques (5, 6) du premier et du deuxième ensemble de bandes conductrices de surface électriques étant disposées à chaque fois en alternance les unes par rapport aux autres,
les extrémités de raccordement des bandes conductrices de surface électriques du premier ensemble de bandes conductrices de surface électriques sont connectées ou peuvent être connectées de manière réversible aux points de contact de la première bande conductrice électriquement conductrice et
les extrémités de raccordement des bandes conductrices de surface électriques du deuxième ensemble de bandes conductrices de surface électriques sont connectées ou peuvent être connectées de manière réversible aux points de contact de la deuxième bande conductrice électriquement conductrice, **caractérisé en ce que**
la couche de maintien magnétisable ou magnétique (34) se trouve du côté avant sur le système de support (3), en particulier la couche de support, et **en ce que** la couche de maintien magnétisable ou magnétique (34) comprend ou représente un revêtement d'enduit, une couche de spatule, une couche de peinture, une couche d'apprêt et/ou une couche de non-tissé, qui est à chaque fois équipée de matériaux magnétisables.

2. Système fonctionnel de surface selon la revendication 1, comprenant en outre
d) au moins un bloc d'alimentation basse tension, connecté ou pouvant être connecté à la bande de contact électrique,
le bloc d'alimentation faisant de préférence partie de la bande de contact, de la bande de recouvrement ou du revêtement d'enduit.

3. Système fonctionnel de surface selon la revendication 1 ou 2, comprenant en outre
e) une bande de recouvrement (20) réalisée en particulier de manière magnétique ou magnétisable, en particulier une bande de pied et/ou de plafond,
en particulier **caractérisé en ce que**
la bande de contact (2) fait partie, en particulier d'un seul tenant, de la bande de recouvrement (20), en particulier de la bande de pied et/ou de plafond.

4. Système fonctionnel de surface selon l'une quelconque des revendications précédentes, **caractérisé en ce que**
le système de support, en particulier la couche de support, est réalisé de manière magnétisable.

5. Système fonctionnel de surface selon l'une quelconque des revendications précédentes, **caractérisé en ce que**
les matériaux magnétisables représentent des matériaux ferri- et/ou ferromagnétiques, par exemple de la magnétite.

6. Système fonctionnel de surface selon l'une quelconque des revendications précédentes, **caractérisé en ce que**
la bande de contact peut être raccourcie, en particulier au moyen de zones d'affaiblissement prédéfinies, par exemple des encoches.

7. Système fonctionnel de surface selon l'une quelconque des revendications précédentes, **caractérisé en ce que**
la pluralité de bandes conductrices de surface disposent d'une largeur transversale sensiblement uniforme ou **en ce que**
la pluralité de bandes conductrices de surface disposent d'une étendue longitudinale sensiblement uniforme ou **en ce que**
la pluralité de bandes conductrices de surface adjacentes s'étendent sensiblement parallèlement ou **en ce que**
la pluralité de bandes conductrices de surface adjacentes sont à chaque fois séparées les unes des autres par une surface sans conducteur (39), en particulier isolées électriquement.

8. Système fonctionnel de surface selon la revendication 7, **caractérisé en ce que** la surface sans conducteur (39) définit à chaque fois une distance transversale (t) entre deux bandes conductrices de surface adjacentes et les bandes conductrices de surface présentent à chaque fois une largeur transversale (b) entre deux surfaces sans conducteur adjacentes (39), la largeur transversale (b) étant au moins aussi grande que, en particulier plus grande que, la distance transversale (t) et/ou un module transversal (h) étant défini comme la somme de la largeur transversale (b) d'une bande conductrice de surface électrique et du double d'une distance transversale (t) de la surface sans conducteur (39).

9. Système fonctionnel de surface selon la revendication 7 ou 8, **caractérisé en ce que** la distance transversale (t) se situe dans la plage d'au moins 1 mm à 10 mm, en particulier de 2 mm à 5 mm, de préférence d'environ 3 mm, et/ou **en ce que** la largeur transversale (b) se situe dans la plage d'au moins 1 mm à 50 mm, en particulier de 15 mm à 35 mm, de préférence d'environ 25 mm.

10. Système fonctionnel de surface selon l'une quelconque des revendications précédentes, comprenant en outre
g) au moins un capteur de courant (8, 8') pour un consommateur électrique, comprenant au moins deux ou trois, de préférence au moins cinq et de manière particulièrement préférée exactement cinq éléments de contact électriquement conducteurs (81, 82, 83, 84, 85), conçus et agencés pour interagir avec deux bandes conductrices de surface électriques adjacentes (5, 6),
le capteur de courant (8, 8') pour un consommateur électrique représentant de préférence un adaptateur de mise en contact contenant un circuit redresseur.

11. Système fonctionnel de surface selon la revendication 10, **caractérisé en ce que** le capteur de courant (8, 8') pour un consommateur électrique comprend au moins un composant de maintien magnétique, en particulier est équipé d'un côté arrière magnétique, qui est tourné ou peut être tourné vers la couche de maintien (34).

12. Système fonctionnel de surface selon la revendication 10 ou 11, **caractérisé en ce que**
le capteur de courant (8, 8') présente au moins deux réceptacles de raccordement, tels que des bornes de raccordement, qui sont conçus et agencés pour recevoir à chaque fois au moins une ligne électrique d'un consommateur électrique.

13. Système fonctionnel de surface selon les revendications 10 à 12, **caractérisé en ce que**
plusieurs, en particulier tous les éléments de contact (81, 82, 83, 84, 85) se situent dans un anneau circulaire, en particulier sur une périphérie circulaire (80), et/ou **en ce que** plusieurs, en particulier tous les éléments de contact adjacents sont espacés les uns des autres sensiblement de la même distance, en particulier plusieurs, de préférence tous les éléments de contact (81, 82, 83, 84, 85) formant un polygone de préférence équilatéral, de préférence au moins un ou exactement un élément de contact (84') étant disposé dans le polygone, en particulier au centre du polygone.

14. Système fonctionnel de surface selon l'une quelconque des revendications 10 à 13, **caractérisé en ce que**
au moins une paire d'éléments de contact du même capteur de courant (8, 8') présente entre eux une distance de contact (k) qui est plus grande que la somme de la largeur transversale (b) d'une bande conductrice de surface électrique et de la distance transversale (t) de la surface sans conducteur (39) et qui est plus petite que la somme du double de la largeur transversale (b) d'une bande conductrice de surface électrique et de la distance transversale (t) de la surface sans conducteur (39), la distance de contact correspondant de préférence sensiblement au module transversal (h).

15. Système fonctionnel de surface selon l'une quelconque des revendications 10 à 14, **caractérisé en ce que**
les éléments de contact (81, 82, 83, 84, 85) sont réalisés en forme d'aiguille, en particulier avec une extrémité d'insertion de forme conique, et/ou en forme de broche, en particulier avec une section cylindrique,
les éléments de contact présentant de préférence une largeur de section transversale (p) qui est plus petite que la distance transversale (t), correspond en particulier sensiblement à la moitié de la distance transversale (t) et/ou est plus petite d'au moins 0,5 mm, de préférence d'au moins 1 mm, que la distance transversale (t).

16. Système fonctionnel de surface selon la revendication 15, **caractérisé en ce que** les éléments de contact présentent une longueur d'élément de contact (n) qui est plus grande qu'une épaisseur de bande (d) des bandes conductrices et/ou est plus grande qu'une épaisseur de système (s) du système de support, la longueur d'élément de contact (n) étant en particulier au moins aussi grande que la somme de l'épaisseur de bande (d) et de l'épaisseur de système (s).

17. Système fonctionnel de surface selon l'une quelconque des revendications précédentes, comprenant en outre
h) au moins un revêtement décoratif (30) se trouvant du côté avant sur le système de support (3), en particulier la couche de support (31), ou sur la couche de maintien magnétisable ou magnétique (34).

18. Système fonctionnel de surface selon l'une quelconque des revendications précédentes, **caractérisé en ce que**
l'au moins une, en particulier la pluralité, de bandes conductrices de surface électriques, en particulier longitudinales (5, 6) sont choisies dans le groupe constitué par les conducteurs de surface métalliques, en particulier en feuille de cuivre ou d'aluminium, les bandes d'encre électriquement conductrice, en particulier appliquée au moyen d'un procédé d'impression, les composés polymères conducteurs et les systèmes à base de fibres de carbone.

19. Système fonctionnel de surface selon l'une quelconque des revendications 4 à 18, comprenant en outre
au moins un objet fonctionnel (100), tel qu'une image, un cadre d'images (110), un support magnétique, une montre murale, un tableau blanc, un panneau, une étagère, une table murale pliable, en particulier contenant une station de charge USB, un élément de décoration, un écran, une surface de projection, un miroir, un porte-bougies, un porte-rideaux, des panneaux en bois, des barres d'images, des carreaux, des rails, un vase, une barre de commande, un auxiliaire de commande, une armoire suspendue, une cheminée décorative, une barre de socle, une lampe (120), un commutateur domotique, un panneau isolant, un panneau acoustique, un haut-parleur, une radio, un système d'annulation active du bruit, un élément chauffant (130), un détecteur de fumée, un dispositif de suivi GPS, un distributeur de liquide, tel qu'un distributeur de savon, ou un distributeur de désinfectant et/ou un capteur, tel qu'un capteur de pièce, par exemple un capteur de température, un capteur de bruit, un capteur de luminosité, un capteur de mouvement, un hygromètre, un capteur de personne, un capteur de vibrations, l'objet fonctionnel (100) étant équipé d'un côté arrière magnétiquement actif (104).

20. Utilisation du système fonctionnel de surface selon l'une quelconque des revendications précédentes pour l'alimentation électrique plane pour des applications basse tension d'au moins un capteur de courant pour un consommateur électrique, comprenant au moins deux ou trois, de préférence au moins cinq et de manière particulièrement préférée exactement cinq éléments de contact électriquement conducteurs, conçus et agencés pour interagir avec deux bandes conductrices de surface électriques adjacentes.

21. Mur ou plafond de bâtiment ou corps acoustique, en particulier paroi acoustique, contenant
au moins un système fonctionnel de surface de bâtiment selon l'une quelconque des revendications 1 à 19.

22. Bâtiment préfabriqué avec un système fonctionnel de surface selon l'une quelconque des revendications 1 à 19 et/ou un mur ou plafond de bâtiment selon la revendication 21.
